(19) Europäisches Patentamt / European Patent Office / Office européen des brevets

(11) **EP 4 117 161 B1**

(12) **FASCICULE DE BREVET EUROPEEN**

(45) Date de publication et mention de la délivrance du brevet:
**20.11.2024 Bulletin 2024/47**

(21) Numéro de dépôt: **22183280.1**

(22) Date de dépôt: **06.07.2022**

(51) Classification Internationale des Brevets (IPC):
**H02M 3/335** *(2006.01)*

(52) Classification Coopérative des Brevets (CPC):
**H02M 3/33584;** H02M 1/0058; H02M 7/05;
H02M 7/4815

(54) **SYSTÈME ET PROCÉDÉ DE COMMANDE AVEC DEGRÉ DE LIBERTÉ ADDITIONNEL POUR UN CONVERTISSEUR DE PUISSANCE PIÉZOÉLECTRIQUE**

STEUERUNG UND STEUERUNGSVERFAHREN MIT ZUSÄTZLICHEM FREIHEITSGRAD FÜR EINEN PIEZOELEKTRISCHEN ENERGIEWANDLER

CONTROLLER AND METHOD FOR CONTROLLING AN PIEZOELECTRIC ENERGY CONVERTER WITH AN ADDITIONAL DEGREE OF FREEDOM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.07.2021 FR 2107345**

(43) Date de publication de la demande:
**11.01.2023 Bulletin 2023/02**

(73) Titulaire: **Commissariat à l'Energie Atomique et aux Energies Alternatives
75015 Paris (FR)**

(72) Inventeurs:
• **DESPESSE, Ghislain
38054 GRENOBLE CEDEX 9 (FR)**
• **TOUHAMI, Mustapha
38054 GRENOBLE CEDEX 9 (FR)**

(74) Mandataire: **Lavoix
2, place d'Estienne d'Orves
75441 Paris Cedex 09 (FR)**

(56) Documents cités:
**WO-A2-2020/252250 FR-A1- 3 086 472**

**Description**

La présente invention concerne un dispositif électronique de pilotage d'un convertisseur d'énergie électrique apte à convertir une ou plusieurs tensions d'entrée en une ou plusieurs tensions de sortie, le convertisseur étant configuré pour délivrer N tension(s) de sortie distincte(s), à partir de E tension(s) d'entrée distincte(s), E et N étant chacun un nombre entier supérieur ou égal à 1. Le convertisseur comporte un élément piézoélectrique et plusieurs interrupteurs aptes à être commandés pour alterner des phases à tension sensiblement constante aux bornes de l'élément piézoélectrique et des phases à charge sensiblement constante aux bornes dudit élément piézoélectrique.

L'invention concerne également un système électronique de conversion d'énergie électrique comprenant un tel convertisseur d'énergie électrique et un tel dispositif électronique de pilotage, ainsi qu'un procédé de pilotage d'un tel convertisseur d'énergie électrique.

L'invention concerne le domaine des systèmes électroniques de conversion d'énergie électrique, en particulier ceux comportant un élément piézoélectrique, notamment des systèmes de conversion en une énergie électrique continue, c'est-à-dire les systèmes de conversion continu-continu, également appelés systèmes de conversion DC-DC (de l'anglais *Direct Current - Direct Current*), et les systèmes de conversion alternatif-continu, également appelés systèmes de conversion AC-DC (de l'anglais *Alternating Current - Direct Current*).

On connait des documents FR 3 064 850 B1, FR 3 086 471 A1 et FR 3 086 472 A1, ainsi que du manuscrit de thèse « *Convertisseurs DC-DC piézoélectrique avec stockage provisoire d'énergie sous forme mécanique* » de Benjamin POLLET, un convertisseur d'énergie électrique et un dispositif électronique de pilotage du type précité.

WO 2020/252250 A2 décrit également un convertisseur d'énergie électrique et un dispositif électronique de pilotage du type précité.

Le convertisseur d'énergie électrique est typiquement un convertisseur continu-continu comportant un élément piézoélectrique, avec un premier interrupteur reliant une première électrode de l'élément piézoélectrique à une première borne d'application d'une première tension, un deuxième interrupteur reliant ladite première électrode de l'élément piézoélectrique à une première borne de fourniture d'une deuxième tension, et au moins un troisième interrupteur connectant la première électrode à une deuxième électrode de l'élément piézoélectrique ou à une borne de fourniture d'une troisième tension, lesdits interrupteurs étant commandés de façon cyclique, à la fréquence principale d'oscillation de l'élément piézoélectrique autour de son mode de résonance présélectionné avec, entre chaque fermeture d'un des interrupteurs, une phase dans laquelle tous les interrupteurs sont ouverts. La fermeture de chaque interrupteur s'effectue sous une tension approximativement nulle à ses bornes. La deuxième électrode de l'élément piézoélectrique est connectée à une deuxième borne d'application de la première tension et à une deuxième borne de fourniture de la deuxième tension et éventuellement à la borne de fourniture de la troisième tension, aussi appelée troisième borne de fourniture.

En régime établi, un cycle de commande comporte typiquement les phases successives suivantes : (I) ouverture de tous les interrupteurs ; (II) fermeture du premier interrupteur ; (III) ouverture de tous les interrupteurs ; (IV) fermeture du troisième interrupteur ; (V) ouverture de tous les interrupteurs ; et (VI) fermeture du deuxième interrupteur.

Pour le pilotage d'un tel convertisseur d'énergie électrique, une stratégie de régulation consiste typiquement à réguler la tension de sortie pour suivre une consigne souhaitée, tout en assurant une commutation à zéro de tension et une synchronisation avec le courant interne de l'élément piézoélectrique, comme décrit dans le document FR 3 064 850 B1, ou encore dans l'article ″Implementation of control strategy for step-down dc-dc converter based on piezoelectric resonator" de Mustapha TOUHAMI et al (EPE '20 ECCE Europe, pp. 1-9).

Toutefois, une grandeur représentative de la sortie du convertisseur, telle que la tension de sortie ou la puissance de sortie, est régulée par un instant de commutation, notamment la fin de la phase (II) via l'ouverture du premier interrupteur dans l'exemple précité, et les autres instants de commutation des interrupteurs en sont en déduit.

Le but de l'invention est alors de proposer un dispositif électronique, et un procédé associé, de pilotage d'un tel convertisseur d'énergie électrique offrant un pilotage amélioré du convertisseur, notamment une meilleure régulation.

A cet effet, l'invention a pour objet un dispositif électronique de pilotage selon la revendication 1.

L'invention est définie par les caractéristiques de la revendication dispositif 1 et de la revendication procédé 11.

Avec le dispositif électronique de pilotage selon l'invention, chaque cycle respectif de résonance comporte alors une phase supplémentaire à tension sensiblement constante, en comparaison avec le dispositif de pilotage de l'état de la technique, le nombre $M_V$ de phases à tension sensiblement constante lors d'un cycle respectif de résonance étant supérieur ou égal à N+3, i.e. Mv ≥ N+3 ; avec chaque demi-cycle comportant au moins deux phases à tension sensiblement constante, alors qu'avec le dispositif de pilotage de l'état de la technique l'un des demi-cycles comporte généralement une seule phase à tension sensiblement constante.

Le nombre de phases à tension sensiblement constante lors de chacun des premier et second demi-cycles, c'est-à-dire lors de chaque demi-cycle respectif de résonance, est alors supérieur ou égal à deux. Chaque cycle de résonance est de préférence constitué des premier et second demi-cycles. Les deux demi-cycles se différencient par une évolution en sens opposé de la déformation mécanique de l'élément piézoélectrique, ou encore par une évolution en sens opposé du courant interne $I_L$ dans la branche motionnelle du modèle électrique équivalent de l'élément piézoélectrique.

Cette phase supplémentaire à tension sensiblement constante permet alors d'avoir un degré de liberté supplémentaire pour la régulation, ce degré de liberté supplémentaire correspondant à la durée de ladite phase supplémentaire. Cette durée est contrôlée par exemple par l'instant de fin de ce palier, ou encore par l'instant de fin du palier précédent.

Cette phase supplémentaire permet alors d'assurer un équilibre de charge électrique, tout en contrôlant l'énergie restituée à la sortie du convertisseur indépendamment de l'énergie stockée dans l'élément piézoélectrique.

Ceci permet alors typiquement de stocker une partie de l'énergie prélevée à la source dans l'élément piézoélectrique quand la puissance d'entrée est supérieure à la puissance de sortie, et ensuite de restituer cette énergie stockée à la sortie quand la puissance d'entrée est inférieure à la puissance de sortie, ce qui permet de fournir à la sortie une puissance/tension constante ou quasi-constante alors que la puissance prélevée sur le réseau est par exemple en $sin(\omega t)^2$, sans nécessité alors la présence d'un condensateur de filtrage, ou à tout le moins en réduisant la capacité de ce condensateur de filtrage.

Le dispositif électronique de pilotage selon l'invention permet aussi de faire face à des variations rapides de puissance de sortie (typiquement dues à l'ajout ou au retrait d'une charge en sortie) avec une dynamique plus rapide de régulation de la tension de sortie grâce à l'énergie tampon stockée mécaniquement dans l'élément piézoélectrique qui est alors immédiatement disponible, cette énergie tampon étant possible de par ladite phase supplémentaire.

Avec le dispositif de pilotage de l'état de la technique, la régulation n'a qu'un seul degré de liberté. Lors d'une perturbation rapide en entrée et/ou en sortie, l'équilibre d'énergie ne peut alors être maintenu, et par conséquent la tension de sortie et/ou la puissance de sortie ne peuvent être maintenues pendant ce régime transitoire.

Suivant d'autres aspects avantageux de l'invention, le dispositif électronique de pilotage est selon l'une quelconque des revendications 2 à 8.

L'invention a aussi pour objet un système électronique de conversion d'énergie électrique selon la revendication 9.

Suivant un autre aspect avantageux de l'invention, le système électronique de conversion d'énergie électrique est selon la revendication 10.

L'invention a également pour objet un procédé de pilotage d'un convertisseur d'énergie électrique selon la revendication 11.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

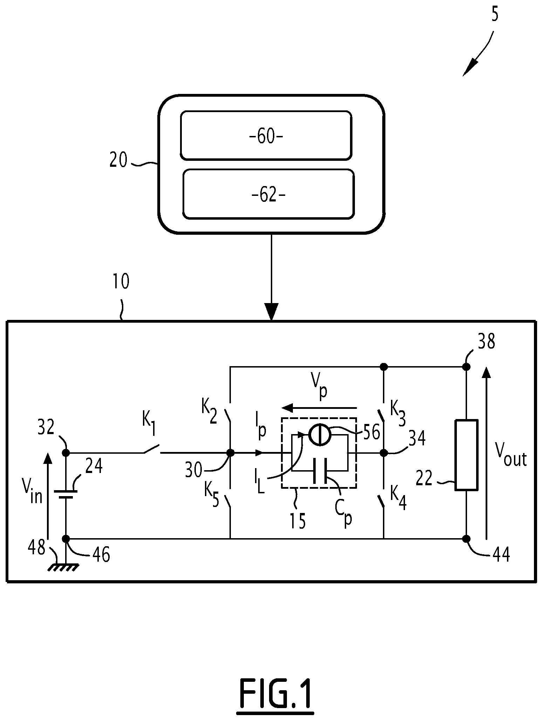

- la figure 1 est une représentation schématique d'un système électronique de conversion d'énergie électrique selon l'invention, comprenant un convertisseur d'énergie électrique comportant un élément piézoélectrique et plusieurs interrupteurs, et un dispositif électronique de pilotage du convertisseur d'énergie électrique pour commander, lors d'un cycle respectif de résonance de l'élément piézoélectrique, une commutation de chacun des interrupteurs pour alterner des phases à tension sensiblement constante aux bornes de l'élément piézoélectrique et des phases à charge sensiblement constante aux bornes dudit élément piézoélectrique, chaque cycle de résonance comportant des premier et second demi-cycles, un courant circulant selon un premier sens dans l'élément piézoélectrique lors du premier demi-cycle et selon un second sens, opposé au premier sens, lors du second demi-cycle ;

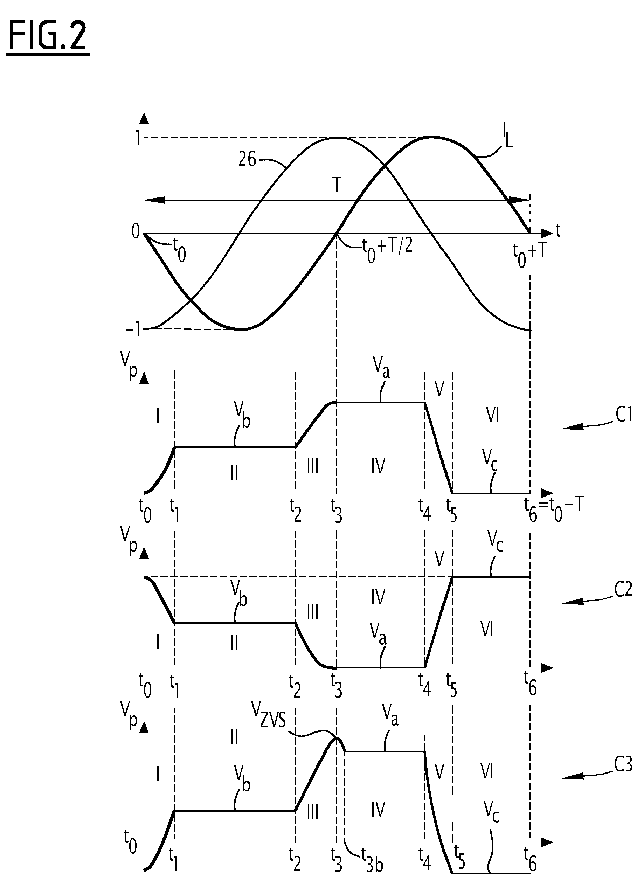

- la figure 2 est un ensemble de courbes représentant un courant circulant dans l'élément piézoélectrique, une déformation mécanique de l'élément piézoélectrique, et la tension aux bornes de l'élément piézoélectrique pour différentes configurations de conversions d'énergie électrique, à savoir une configuration abaisseur de tension (transfert de puissance de $V_a$ vers $V_b$), une configuration élévateur de tension (transfert de puissance de $V_b$ vers $V_c$) et une configuration fortement abaisseur de tension (transfert de puissance de $V_a$ vers $V_b$ et $V_c$); avec le dispositif de pilotage de l'état de la technique ;
- la figure 3 est une vue analogue à celle de la figure 2
- la figure 4 est une vue analogue à celle de la figure 3
- la figure 5 est une vue analogue à celle de la figure 3
- la figure 6 est une représentation schématique d'une régulation d'un premier paramètre associé au premier demi-cycle et d'un deuxième paramètre associé au deuxième demi-cycle, chacun des premier et deuxième paramètres étant une variable représentative d'un instant temporel de fin d'une phase respective à tension sensiblement constante ;
- la figure 7 est une vue de courbes du courant interne à l'élément piézoélectrique, ainsi que de la puissance de sortie et de la tension de sortie délivrées par le convertisseur avec, d'une part, un premier ensemble de telles courbes obtenu avec le dispositif de pilotage de l'état de la technique, et d'autre part, un deuxième ensemble de telles courbes obtenu avec le dispositif de pilotage selon l'invention ; selon un premier exemple correspondant à une augmentation de la puissance de sortie ;
- la figure 8 est une vue analogue à celle de la figure 7, selon un deuxième exemple correspondant à une diminution de la puissance de sortie du convertisseur d'énergie électrique ;

- la figure 9 est un organigramme d'un procédé, selon l'invention, de pilotage du convertisseur d'énergie électrique de la figure 1, le procédé étant mis en oeuvre par le dispositif électronique de pilotage de la figure 1 ;
- la figure 10 est une vue représentant, d'une part, un premier cycle de conversion en représentation $V_p$ versus Q obtenu avec le dispositif de pilotage de l'état de la technique, et d'autre part, un deuxième cycle de conversion en représentation $V_p$ versus Q obtenu avec le dispositif de pilotage selon l'invention ;
- la figure 11 est une vue de courbes de puissance d'entrée et de puissance de sortie dans le cas d'un système de conversion de type alternatif-continu à absorption sinusoïdale avec, d'une part, un premier ensemble de telles courbes de puissance obtenu avec le dispositif de pilotage de l'état de la technique, et d'autre part, un deuxième ensemble de telles courbes de puissance obtenu avec le dispositif de pilotage selon l'invention ; et
- la figure 12 est une vue schématique d'exemples de couplage mécanique d'au moins une masse additionnelle avec l'élément piézoélectrique, l'au moins une masse additionnelle permettant d'échanger de l'énergie mécanique avec l'élément piézoélectrique.

Dans la suite de la description, l'expression « sensiblement égal(e) à » définit une relation d'égalité à plus ou moins 10%, de préférence à plus ou moins 5%.

Dans la suite de la description, l'expression « lors d'un cycle » est synonyme de l'expression « au cours d'un cycle », et de même l'expression « lors d'un demi-cycle » est synonyme de l'expression « au cours d'un demi-cycle ».

Sur la figure 1, un système électronique de conversion d'énergie électrique 5 comprend un convertisseur d'énergie électrique 10 comportant un élément piézoélectrique 15 et plusieurs interrupteurs $K_1, K_2, K_3, K_4, K_5$ aptes à être commandés pour alterner des phases à tension sensiblement constante aux bornes de l'élément piézoélectrique 15 et des phases à charge sensiblement constante aux bornes dudit élément piézoélectrique 15 ; et un dispositif électronique 20 de pilotage du convertisseur d'énergie électrique 10.

Le système électronique de conversion d'énergie électrique 5 est typiquement un système de conversion en une énergie électrique continue, tel qu'un système de conversion continu-continu apte à convertir une première énergie ou tension électrique continue reçue en entrée en une deuxième énergie ou tension électrique continue délivrée en sortie, ou encore un système de conversion alternatif-continu apte à convertir une énergie ou tension électrique alternative reçue en entrée en une énergie ou tension électrique continue délivrée en sortie du système de conversion 5.

Lorsque le système de conversion d'énergie électrique 5 est un système de conversion alternatif-continu, le système de conversion d'énergie électrique 5 comprend de préférence en outre un redresseur de tension, non représenté, connecté en entrée du convertisseur d'énergie électrique 10 et apte à redresser la tension électrique alternative reçue en entrée du système de conversion 5 pour délivrer une tension électrique redressée en entrée du convertisseur 10, le convertisseur d'énergie électrique 10 étant de préférence un convertisseur continu-continu apte à convertir une énergie ou tension électrique continue en une autre énergie ou tension électrique continue. Le redresseur de tension est par exemple un pont redresseur, tel qu'un pont de diodes. En variante, le redresseur de tension est formé en partie par des interrupteurs du convertisseur 10.

L'homme du métier observera que ces différents exemples pour le système conversion 5, qu'il s'agisse d'un système de conversion continu-continu ou bien d'un système de conversion alternatif-continu, sont également présentés dans les documents FR 3 086 471 A1 et FR 3 086 472 A1, notamment en regard de leurs figures 1 à 3, 10, 15, 17 et 19 à 20.

Le convertisseur d'énergie électrique 10 est de préférence un convertisseur continu-continu, et est également appelé convertisseur DC-DC. Le convertisseur continu-continu a généralement pour rôle de réguler une tension d'alimentation d'une charge 22 à une valeur stable, en étant alimenté par une source d'énergie 24 fournissant une tension sensiblement continue. La source d'énergie 24 est par exemple une batterie ou un panneau solaire.

Le convertisseur d'énergie électrique 10 est alors configuré pour élever la valeur de la tension continue entre son entrée et sa sortie, et est alors également appelé convertisseur continu-continu élévateur, ou encore convertisseur continu-continu fortement élévateur ; ou bien est configuré pour abaisser la valeur de la tension continue entre son entrée et sa sortie, et est alors appelé convertisseur continu-continu abaisseur, avec également une variante de convertisseur continu-continu fortement abaisseur.

Le convertisseur d'énergie électrique 10 est configuré pour délivrer N tension(s) de sortie distincte(s), à partir de E tension(s) d'entrée distincte(s), E et N étant chacun un nombre entier supérieur ou égal à 1.

Dans l'exemple de la figure 1, le convertisseur d'énergie électrique 10 est configuré pour délivrer une tension de sortie, notée $V_{out}$, à partir d'une tension d'entrée, notée $V_{in}$, le nombre E de tension(s) d'entrée et le nombre N de tension(s) de sortie étant alors chacun égal à 1.

En variante non représentée, le convertisseur d'énergie électrique 10 est configuré pour délivrer plusieurs tensions de sortie distinctes à partir d'une ou plusieurs tensions d'entrée distinctes, le nombre N de tensions de sortie distinctes étant alors supérieur à 1. En variante encore, le convertisseur d'énergie électrique 10 est configuré pour délivrer une ou plusieurs tensions de sortie distincte(s) à partir de plusieurs tensions d'entrée distinctes, le nombre E de tensions d'entrée distinctes étant alors supérieur à 1. En variante encore, le convertisseur d'énergie électrique 10 est configuré pour délivrer plusieurs tensions de sortie distinctes à partir de plusieurs tensions d'entrée distinctes, les nombres E et N étant alors chacun supérieurs à 1. Selon ces variantes, la ou les tensions d'entrée sont notées $V_{ek}$ où k est un indice entier associé à la tension d'entrée et compris entre 1 et E, et la ou les tensions de sortie distinctes sont notées $V_{sl}$, où I est un indice entier associé à la tension de sortie et compris entre 1 et N.

Lorsque le convertisseur d'énergie électrique 10 est configuré pour délivrer plusieurs tensions de sortie distinctes, le convertisseur 10 est typiquement connecté à plusieurs charges 22, tel que représenté par exemple à la figure 17 du document FR 3 086 471 A1.

De manière analogue, lorsque le convertisseur d'énergie électrique 10 est configuré pour délivrer une ou plusieurs tension(s) de sortie distincte(s) à partir de plusieurs tensions d'entrée distinctes, le convertisseur 10 est alors alimenté par plusieurs sources d'énergie 24.

Le convertisseur d'énergie électrique 10 comporte l'élément piézoélectrique 15, et le dispositif de pilotage 20 est configuré pour faire fonctionner le matériau piézoélectrique de l'élément piézoélectrique 15 à sa résonance afin d'exploiter des phases de transfert de charge permettant de s'affranchir de l'utilisation d'un élément inductif, tout en régulant la tension de sortie en conservant la résonance du matériau piézoélectrique, c'est-à-dire avec des cycles de commutation répétés à une fréquence de fonctionnement dépendant de la fréquence de résonance de l'élément piézoélectrique 15, et en ajustant les durées de phases de commutation respectives à l'intérieur du cycle de résonance.

Comme connu en soi, l'oscillation mécanique de l'élément piézoélectrique 15 est approximativement sinusoïdale, ainsi que représenté par la courbe 26 à la figure 2 illustrant la déformation mécanique de l'élément piézoélectrique 15 au cours d'un cycle de résonance respectif. Une augmentation ou une diminution de l'énergie stockée sur une période conduit respectivement à une augmentation ou à une diminution de l'amplitude d'oscillation. Par ailleurs, lors d'une phase à charge sensiblement constante aux bornes de l'élément piézoélectrique 15, c'est-à-dire lorsque l'élément piézoélectrique 15 est placé dans un circuit électrique sensiblement ouvert, avec un faible échange de charges électriques entre l'élément piézoélectrique 15 et l'extérieur, une augmentation de l'amplitude des oscillations engendre une augmentation de l'amplitude d'oscillation de la tension $V_p$ aux bornes de l'élément piézoélectrique 15, et lors d'une phase à tension sensiblement constante aux bornes de l'élément piézoélectrique 15, cette augmentation d'amplitude d'oscillation conduit à une augmentation d'un courant $I_L$ circulant dans l'élément piézoélectrique 15.

Par charge sensiblement constante, on entend un échange d'une charge avec l'extérieur qui est inférieur à 10% de la charge qui aurait été échangée avec l'extérieur si la tension avait été maintenue constante. Autrement dit, par charge sensiblement constante, on entend une variation de charge inférieure à 10% de la charge qui aurait été échangée avec l'extérieur de l'élément piézoélectrique 15 si la tension aux bornes de l'élément piézoélectrique 15 avait été maintenue constante sur la durée temporelle considérée.

Par circuit électrique sensiblement ouvert, on entend un circuit dont un éventuel courant de fuite conduit à une variation de charge de l'élément piézoélectrique 15 inférieure à 10% de la charge qui aurait été échangée avec l'extérieur de l'élément piézoélectrique 15 si la tension aux bornes de l'élément piézoélectrique 15 avait été maintenue constante sur la durée temporelle considérée.

Par tension sensiblement constante, on entend une variation de tension inférieure à 20%, de préférence inférieure à 10%, de la tension d'entrée ou de sortie du convertisseur 10. À titre d'exemple, si la tension d'entrée du convertisseur 10 est égale à 100V, alors la variation de tension lors de chaque phase à tension sensiblement constante, c'est-à-dire sur chaque palier à tension sensiblement constante, est inférieure à 20% de cette tension, c'est-à-dire inférieure à 20V ; de préférence inférieure à 10 % de cette tension, c'est-à-dire inférieure à 10V.

Le convertisseur 10 comporte alors plusieurs interrupteurs $K_1$, $K_2$, $K_3$, $K_4$, $K_5$ aptes à être commandés pour alterner des phases à tension sensiblement constante et des phases à charge sensiblement constante aux bornes de l'élément piézoélectrique 15, à l'intérieur de périodes de durée sensiblement constante correspondant à la fréquence de fonctionnement du convertisseur 10, dépendant de la fréquence de résonance, également appelée fréquence propre, de l'élément piézoélectrique 15. Les phases à charge sensiblement constante permettent, en régime établi ou permanent, de passer d'une tension constante à une autre et de fermer les interrupteurs qui doivent l'être lorsque la tension à leurs bornes est de préférence nulle afin d'avoir une commutation dite à zéro de tension, également appelée commutation ZVS (de l'anglais *Zéro Voltage Switching*).

Dans l'exemple de la figure 1, le convertisseur d'énergie électrique 10 comporte cinq interrupteurs $K_1$, $K_2$, $K_3$, $K_4$, $K_5$, à savoir un premier interrupteur $K_1$, un deuxième interrupteur $K_2$, un troisième interrupteur $K_3$, un quatrième interrupteur $K_4$ et un cinquième interrupteur $K_5$. Le premier interrupteur $K_1$ relie alors une première électrode 30 de l'élément piézoélectrique 15 à une première borne 32 d'application de la tension d'entrée $V_{in}$ ; le deuxième interrupteur $K_2$ relie la première électrode 30 de l'élément piézoélectrique 15 à une première borne 38 de fourniture de la tension de sortie $V_{out}$ ; le troisième interrupteur $K_3$ relie une deuxième électrode 34 de l'élément piézoélectrique 15 à la première borne 38 de fourniture de la tension de sortie $V_{out}$ ; le quatrième interrupteur $K_4$ relie la deuxième électrode 34 de l'élément piézoélectrique 15 à une deuxième borne 44 de fourniture de la tension de sortie $V_{out}$ ; et le cinquième interrupteur $K_5$ relie la première électrode 30 de l'élément piézoélectrique 15 à une deuxième borne 46 d'application de la tension d'entrée $V_{in}$. Dans l'exemple de la figure 1, la deuxième borne 46 d'application de la tension d'entrée $V_{in}$ est

reliée à la deuxième borne 44 de fourniture de la tension de sortie $V_{out}$, ces deuxièmes bornes 44, 46 étant elles-mêmes connectées à une masse électrique 48.

Chaque interrupteur du convertisseur 10, à savoir chacun des premier, deuxième, troisième, quatrième et cinquième interrupteurs $K_1$, $K_2$, $K_3$, $K_4$, $K_5$ est de préférence un interrupteur unidirectionnel en courant et unidirectionnel en tension, sauf pour l'interrupteur $K_2$ bidirectionnel en tension. Chaque interrupteur $K_1$, $K_2$, $K_3$, $K_4$, $K_5$ comprend par exemple un transistor et une diode antiparallèle intrinsèque au transistor, non représentés. Le transistor est, par exemple, un transistor à effet de champ à grille isolée, également appelé MOSFET (de l'anglais *Métal Oxide Semiconductor Field Effect Transistor)*. En variante, le transistor est un transistor bipolaire ; un transistor bipolaire à grille isolée, également appelé IGBT (de l'anglais *Insulated Gate Bipolar Transistor)* ; un transistor à base de silicium (Si), un transistor à base de GaN (de l'anglais *Gallium Nitride)* ; un transistor à base de carbure de silicium (SiC), ou un transistor à base de diamant, ou encore un thyristor, ou encore un switch mécanique, tel qu'un micro-switch MEMS (de l'anglais *MicroElectroMechanical System)*.

L'élément piézoélectrique 15 est connu en soi, et est typiquement modélisé, proche du mode de résonnance exploité, sous la forme d'un condensateur $C_p$ et de la branche résonante 56 connectée en parallèle du condensateur $C_p$, le condensateur $C_p$ et la branche résonante 56 étant connectés entre les première et deuxième électrodes 30, 34 de l'élément piézoélectrique. La branche résonante 56 est typiquement une branche RLC formée d'un condensateur, d'une résistance et d'une inductance connectés en série et non représentés. La tension $V_p$ aux bornes de l'élément piézoélectrique correspond alors typiquement à la tension aux bornes du condensateur $C_p$.

L'homme du métier comprendra bien entendu que les bornes de l'élément piézoélectrique 15 correspondent aux première 30 et deuxième 34 électrodes de l'élément piézoélectrique 15, et sont alors également notées bornes 30, 34 de l'élément piézoélectrique. Dans la présente description, les bornes 30, 34 de l'élément piézoélectrique sont alors identiques aux électrodes 30, 34 de l'élément piézoélectrique.

La fréquence de résonance est la fréquence à laquelle oscille l'élément piézoélectrique 15 et par conséquent son courant $I_L$, visible sur la figure 1. Le cycle de conversion est synchronisé sur un mouvement mécanique de l'élément piézoélectrique 15, et la fréquence du pilotage est alors calée sur la fréquence d'oscillation mécanique. En pratique, cette fréquence d'oscillation dépend du point de fonctionnement du convertisseur 10 : valeurs des trois paliers de tension et du courant de sortie. En fonction du point de fonctionnement, cette fréquence d'oscillation évolue typiquement entre la fréquence de résonance dite série de l'élément piézoélectrique 15 ($\omega_s$=1/√(LC) où L et C correspondent aux inductance et capacité d'une branche résonante 56 décrite ci-après) et la fréquence de résonance dite parallèle de l'élément piézoélectrique 15 ($\omega_p$=1/√(L*C*$C_p$/(C+$C_p$))), également respectivement appelés fréquence de résonance et fréquence d'antirésonance de l'élément piézoélectrique 15. La fréquence de fonctionnement du convertisseur 10 est alors comprise entre ces deux fréquences de résonance et d'antirésonance de l'élément piézoélectrique 15. Le point de fonctionnement varie lentement au regard de la fréquence d'oscillation de l'élément piézoélectrique 15. Le point de fonctionnement évolue typiquement à moins de 10kHz, alors que la fréquence d'oscillation de l'élément piézoélectrique 15 est typiquement supérieure ou égale à 100kHz. De ce fait, la fréquence de fonctionnement du convertisseur 10 évolue peu d'une période à la suivante.

D'une manière générale, pour le convertisseur d'énergie électrique 10 avec l'élément piézoélectrique 15 et piloté par le dispositif électronique de pilotage 20, le nombre de phases à tension sensiblement constante est supérieur ou égal à 4, ce nombre de phases à tension sensiblement constante étant d'au moins 3 avec un dispositif de pilotage de l'état de la technique, et chaque phase à tension sensiblement constante est susceptible d'être obtenue à partir d'une combinaison quelconque des tensions d'entrée et de sortie, en valeur positive ou négative, ou encore d'être de tension nulle. Le convertisseur d'énergie 10 permet alors d'échanger de l'énergie entre les phases à tension sensiblement constante, et par voie de conséquence, avec les tensions ou combinaisons de tensions utilisées pour obtenir ces phases à tension sensiblement constante. Il est notamment possible de transférer de l'énergie d'une phase à tension sensiblement constante de faible tension vers une phase à tension sensiblement constante de tension plus élevée, et par le jeu des combinaisons précitées obtenir au final un convertisseur abaisseur de tension, ce qui peut paraître contre-intuitif. Inversement, il est également possible de transférer de l'énergie d'une phase à tension sensiblement constante de tension élevée vers une phase à tension sensiblement constante de tension plus faible, et par le jeu des combinaisons précitées obtenir au final un convertisseur élévateur de tension. L'homme du métier comprendra alors qu'il est possible d'avoir un cycle élévateur vu par l'élément piézoélectrique 15 alors que le convertisseur d'énergie électrique 10 est un convertisseur abaisseur, et inversement d'avoir un cycle abaisseur vu par l'élément piézoélectrique 15 alors que le convertisseur d'énergie électrique 10 est un convertisseur élévateur.

Par convention, si un courant est fourni à l'élément piézoélectrique 15 lors de la phase à tension sensiblement constante correspondant à la tension la plus élevée au cours d'un cycle de résonance, alors le cycle est considéré comme un cycle abaisseur pour l'élément piézoélectrique 15. Inversement, si un courant est débité, ou encore tiré, depuis l'élément piézoélectrique 15 lors de ladite phase à tension sensiblement constante pour laquelle la tension est la plus élevée au cours du cycle de résonance, alors le cycle est considéré comme un cycle élévateur pour l'élément piézoélectrique 15. Comme indiqué précédemment, le cycle de conversion vu par l'élément piézoélectrique 15 est susceptible d'être un cycle élévateur alors que le convertisseur d'énergie électrique 10 fonctionne en convertisseur abaisseur, et inversement le cycle de conversion vu par l'élément piézoélectrique 15 est susceptible d'être un cycle abaisseur alors que le convertisseur d'énergie électrique 10 fonctionne en convertisseur élévateur.

Le dispositif électronique de pilotage 20 est configuré pour piloter le convertisseur d'énergie électrique 10, en particulier pour piloter la commande des interrupteurs $K_1$, $K_2$, $K_3$, $K_4$, $K_5$ du convertisseur, afin d'alterner des phases à tension sensiblement constante aux bornes de l'élément piézoélectrique 15 et des phases à charge sensiblement constante, c'est-à-dire en circuit sensiblement ouvert, aux bornes dudit élément piézoélectrique 15.

Le dispositif électronique de pilotage 20 comprend un module 60 commande d'une commutation respective de chaque interrupteur $K_1$, $K_2$, $K_3$, $K_4$, $K_5$.

En complément, le dispositif électronique de pilotage 20 comprend un module 62 de régulation de paramètres $\delta_{buffer}$, $t_4$ associés au cycle de résonance de l'élément piézoélectrique 15.

Le module de commande 60 et le module de régulation 62 sont par exemple réalisés chacun sous forme d'un circuit électronique comportant un ou plusieurs composants électroniques, et notamment des comparateurs lorsque des comparaisons sont effectuées.

En variante, le module de commande 60 et le module de régulation 62 sont chacun réalisés sous forme d'un composant logique programmable, tel qu'un FPGA (de l'anglais *Field Programmable Gate Array)*, ou sous forme d'un circuit intégré, tel qu'un ASIC (de l'anglais *Application Spécifie Integrated Circuit*) ou encore sous forme d'un calculateur, tel qu'un microcontrôleur, un processeur. En variante encore, le module de commande 60 et le module de régulation 62 sont implémentés ensemble au sein d'un unique composant matériel, tel qu'un unique composant logique programmable, un unique circuit intégré, ou unique calculateur.

Le module de commande 60 est configuré pour commander, lors d'un cycle respectif de résonance de l'élément piézoélectrique 15, une commutation de chacun des interrupteurs $K_1$, $K_2$, $K_3$, $K_4$, $K_5$ pour alterner des phases II, IV, VI, VIII à tension sensiblement constante aux bornes 30, 34 de l'élément piézoélectrique 15 et des phases I, III, V, VII à charge sensiblement constante aux bornes 30, 34 dudit élément piézoélectrique 15. Chaque cycle de résonance comportant des premier et second demi-cycles, le courant $I_L$ circulant selon un premier sens dans l'élément piézoélectrique 15 lors du premier demi-cycle et selon un second sens, opposé au premier sens, lors du second demi-cycle.

Selon l'invention, le module de commande 60 est configuré pour commander la commutation de chacun des interrupteurs $K_1$, $K_2$, $K_3$, $K_4$, $K_5$ de telle sorte que le nombre $M_V$ de phases II, IV, VI, VIII à tension sensiblement constante lors d'un cycle respectif de résonance est supérieur ou égal à la somme de E, N et deux, et que chacun des premier et second demi-cycles comporte au moins deux phases II, IV ; VI, VIII à tension sensiblement constante.

Le nombre $M_V$ de phases à tension sensiblement constante vérifie alors l'équation suivante :

(1)

$$M_V \geq E + N + 2$$

où $M_V$ représente le nombre de phases à tension sensiblement constante lors d'un cycle respectif de résonance ; et E, et respectivement N, représentent le nombre de tension(s) d'entrée distincte(s), et respectivement le nombre de tension(s) de sortie distincte(s), E et N étant chacun un nombre entier supérieur ou égal à 1.

Le nombre total M de phases à tension sensiblement constante et de phases à charge sensiblement constante aux bornes de l'élément piézoélectrique 15 au cours d'un cycle de résonance, vérifie alors typiquement l'équation suivante :

(2)

$$M \geq 2 \cdot (E + N + 2)$$

où M représente le nombre total de phases à tension sensiblement constante et de phases à charge sensiblement constante lors d'un cycle respectif de résonance ; et E, et respectivement N, représentent le nombre de tension(s) d'entrée distincte(s), et respectivement le nombre de tension(s) de sortie distincte(s), E et N étant chacun un nombre entier supérieur ou égal à 1.

En complément, ce nombre total M de phases à tension sensiblement constante et de phases à charge sensiblement constante vérifie de préférence l'équation suivante :

(3)

$$M = M_V + M_C$$

où M représente le nombre total de phases à tension sensiblement constante et de phases à charge sensiblement constante lors d'un cycle respectif de résonance ;

$M_V$ représente le nombre de phases à tension sensiblement constante lors d'un cycle respectif de résonance ; et

$M_C$ représente le nombre de phases à charge sensiblement constante lors d'un cycle respectif de résonance.

En complément encore, le nombre $M_V$ de phases à tension sensiblement constante lors d'un cycle respectif de résonance et le nombre $M_C$ de phases à charge sensiblement constante lors d'un cycle respectif de résonance sont de préférence égaux, et vérifient alors l'équation suivante :

(4)

$$M_V = M_C$$

L'homme du métier observera que bien que le convertisseur d'énergie électrique 10 comporte cinq interrupteurs $K_1$, $K_2$, $K_3$, $K_4$, $K_5$ dans l'exemple de la figure 1, il suffit que le convertisseur 10 comporte au moins trois interrupteurs pour la mise en oeuvre de l'invention, en particulier pour avoir au moins quatre phases à tension sensiblement constante lors d'un cycle respectif de résonance, c'est-à-dire pour que le nombre $M_V$ vérifie l'équation (1) précédente dans le cas où E et N égal à 1, et pour que chacun des premier et second demi-cycles comporte au moins deux phases à tension sensiblement constante. A titre d'exemple, dans la variante décrite ci-après où une valeur $V_{buffer}$ de la tension lors de la phase supplémentaire à tension sensiblement constante au cours du premier demi-cycle est sensiblement égale à la valeur de la tension lors de l'une des phases à tension sensiblement constante au cours du second demi-cycle, telle que la valeur $V_a$ ou la valeur $V_c$, seuls trois interrupteurs sont nécessaires pour obtenir les différentes phases à tension sensiblement constante aux valeurs $V_a$, $V_b$ et $V_c$ respectives.

Le module de régulation 62 est configuré pour réguler un premier paramètre $\delta_{buffer}$ associé au premier demi-cycle et un deuxième paramètre $t_4$ associé au deuxième demi-cycle, chacun des premier $\delta_{buffer}$ et deuxième $t_4$ paramètres étant une variable représentative d'un instant temporel de fin d'une phase respective à tension sensiblement constante.

De préférence, le module de régulation 62 est configuré pour réguler le premier paramètre $\delta_{buffer}$ en fonction d'une grandeur $G_{out}$ représentative de la sortie du convertisseur 10, et le deuxième paramètre $t_4$ en fonction d'un niveau souhaité de réserve d'énergie ou bien en fonction du premier paramètre $\delta_{buffer}$.

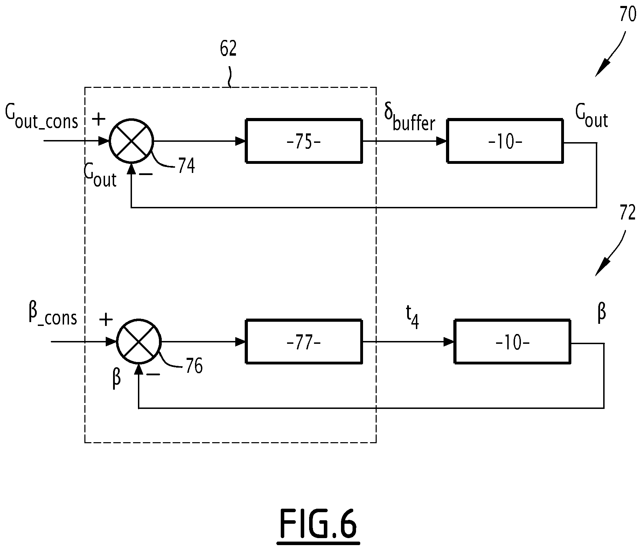

Dans l'exemple de la figure 6, le module de régulation 62 est configuré pour réguler le premier paramètre $\delta_{buffer}$ qui est régulé via une première boucle de régulation 70, et le deuxième paramètre $t_4$ qui est régulé via une deuxième boucle de régulation 72, distincte de la première boucle de régulation 70. La première boucle de régulation 70 est typiquement plus rapide que la deuxième boucle de régulation 72, comme cela sera décrit plus en détail par la suite en regard de la figure 6.

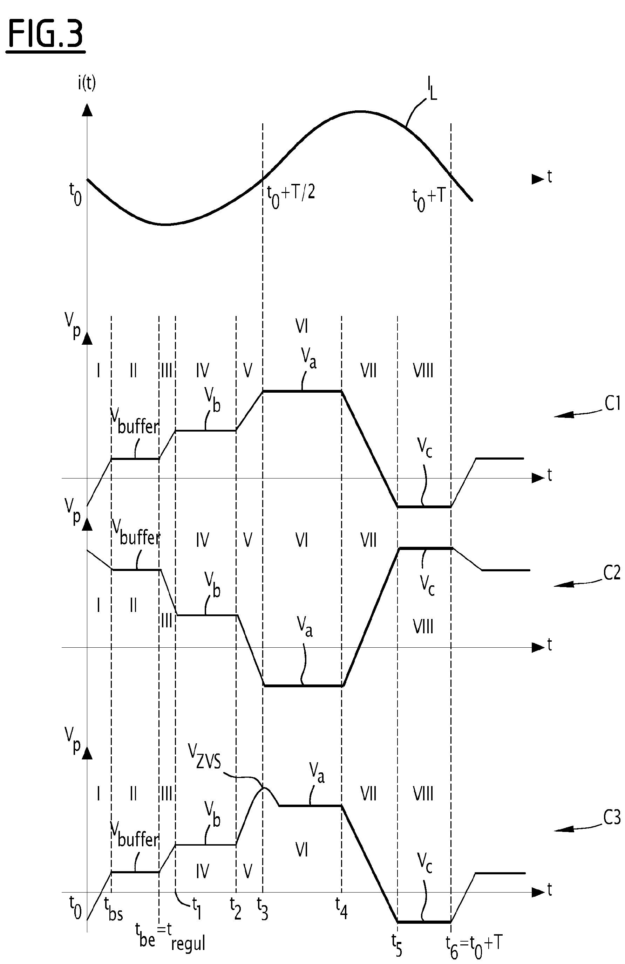

Des exemples du cycle de résonance de l'élément piézoélectrique 15 avec alternance entre phases à charge sensiblement constante et phases à tension sensiblement constante vont être à présent décrits en regard des figures 2 à 5, la figure 2 correspondant à une mise en oeuvre avec le dispositif de pilotage de l'état de la technique, et les figures 3 à 5 correspondant à des mises en oeuvre avec le dispositif de pilotage 20

Avec le dispositif de pilotage de l'état de la technique, le nombre total de phases à tension sensiblement constante et de phases à charge sensiblement constante aux bornes de l'élément piézoélectrique 15 au cours d'un cycle de résonance est supérieur ou égal à six. Dans l'exemple de la figure 2 obtenu avec le dispositif de pilotage de l'état de la technique, ce nombre total de phases est égal à six.

Ces phases successives d'un cycle de résonance vont alors être décrites dans l'exemple de la figure 2 à six phases, selon un format générique correspondant aux différentes configurations du convertisseur 10. Sont représentés dans ce format générique trois exemples non limitatifs de convertisseurs : abaisseur, élévateur et fortement abaisseur.

Dans l'exemple de la figure 2, ces différentes phases correspondent à un fonctionnement en régime établi ou permanent du convertisseur 10, c'est-à-dire à partir du moment où la résonance du matériel piézoélectrique est atteinte avec une amplitude sensiblement constante, et alors avec des échanges d'énergie et de charge sensiblement équilibrés sur chaque période T du cycle de résonance. Pour simplifier la description, les pertes dans les interrupteurs $K_1$, $K_2$, $K_3$, $K_4$, $K_5$ à l'état passant, ainsi que les pertes dans le matériau piézoélectrique à la résonance sont négligées.

La figure 2 représente alors l'évolution du courant $I_L$ circulant dans l'élément piézoélectrique 15 ; de la tension $V_p$ aux bornes de l'élément piézoélectrique 15, également représentée sur la figure 1 ; et de la déformation mécanique de l'élément piézoélectrique 15, représentée par la courbe 26 ; ceci au cours d'un cycle de résonance et pour trois configurations de conversion distinctes du convertisseur 10, à savoir une première configuration C1 en abaisseur de tension vu de l'élément piézoélectrique 15, une deuxième configuration C2 en élévateur de tension vu de l'élément piézoélectrique 15, et une troisième configuration C3 en fortement abaisseur de tension vu de l'élément piézoélectrique 15.

Par convention, un premier instant temporel de commutation en l'instant temporel ta, ou encore en l'instant temporel $t_6$ décrit ci-après, correspond à un passage par zéro et par valeurs décroissantes du courant $I_L$ circulant dans l'élément piézoélectrique 15.

A partir de ce passage par zéro du courant $I_L$ circulant dans l'élément piézoélectrique 15, correspondant à ce premier instant temporel de commutation, débute alors une première phase I correspondant à une phase à charge sensiblement constante, cette première phase I s'écoulant entre l'instant temporel $t_0$ et l'instant temporel $t_1$ dans l'exemple de la figure 2. La fin de cette première phase I correspond au moment où la tension $V_p$ aux bornes de l'élément piézoélectrique 15 atteint une valeur $V_b$ prédéfinie.

En l'instant temporel $t_1$, débute alors une deuxième phase II correspondant à une phase à tension sensiblement constante à la valeur $V_b$, le début de cette deuxième phase II étant alors obtenu par la fermeture d'au moins un interrupteur respectif parmi les interrupteurs $K_1$, $K_2$, $K_3$, $K_4$, $K_5$, le ou les interrupteurs fermés en cet instant dépendant de la valeur $V_b$, la valeur $V_b$ étant par exemple égale à la tension d'entrée $V_{in}$ ou encore à la tension de sortie $V_{out}$. L'instant temporel $t_1$ forme alors un deuxième instant temporel de commutation.

Un troisième instant temporel de commutation, noté $t_2$, correspond à l'ouverture d'au moins un des interrupteurs fermés précédemment en l'instant temporel $t_1$, et la tension $V_p$ aux bornes de l'élément piézoélectrique 15 passe alors d'une tension précédente $V_b$ à une position de circuit ouvert. En ce troisième instant temporel de commutation $t_2$ commence alors une troisième phase III durant jusqu'à un instant temporel $t_3$ correspondant à un passage à zéro du courant $I_L$ circulant dans l'élément piézoélectrique 15. Préalablement, l'instant temporel $t_2$ a été défini de sorte qu'en l'instant temporel $t_3$, la tension $V_p$ aux bornes de l'élément piézoélectrique 15 atteigne une valeur $V_a$ ou bien une valeur Vzvs correspondant à la valeur permettant une commutation à zéro de tension de l'interrupteur correspondant.

A l'instant temporel $t_3$, commence une quatrième phase IV. En cet instant temporel $t_3$, si la valeur $V_{ZVS}$ est égale à la valeur $V_a$, alors l'élément piézoélectrique 15 peut passer de la phase à charge sensiblement constante (ou en circuit sensiblement ouvert) à une phase suivante à tension sensiblement constante à la valeur $V_a$, et l'instant temporel $t_3$ forme alors un quatrième instant temporel de commutation correspondant à la fermeture d'au moins un autre interrupteur respectif parmi les interrupteurs $K_1$, $K_2$, $K_3$, $K_4$, $K_5$, le ou les interrupteurs fermés en cet instant dépendant de la valeur $V_a$, la valeur $V_a$ étant par exemple égale à la tension d'entrée $V_{in}$, à la tension nulle de la masse électrique 48 ou encore à la différence de tension $V_{in}$-$V_{out}$ égale à la tension d'entrée $V_{in}$ moins la tension de sortie $V_{out}$. Dans l'exemple de la figure 2, le quatrième instant temporel de commutation est l'instant $t_3$ dans le cas des première et deuxième configurations C1, C2.

Si en l'instant temporel $t_3$, la valeur $V_{ZVS}$ est différente de la valeur $V_a$, alors l'élément piézoélectrique 15 est maintenu en circuit ouvert jusqu'à ce que le ou les interrupteurs précités pour l'obtention de la valeur $V_a$ passent par une tension nulle à leurs bornes, et le quatrième instant temporel de commutation correspondant à la fermeture du ou de ces interrupteurs et au début de la phase à tension sensiblement constante à la valeur $V_a$ est alors noté $t_{3b}$, comme représenté sur la figure 2 dans le cas de la troisième configuration C3.

Cette quatrième phase IV est alors une phase à tension sensiblement constante à la valeur $V_a$, et dure jusqu'à un instant temporel $t_4$ qui forme un paramètre de réglage du convertisseur 10, cet instant temporel $t_4$ permettant de définir la tension, le courant ou encore la puissance souhaitée en sortie du convertisseur 10.

L'instant temporel $t_4$ correspond alors à la fin de la quatrième phase IV et à l'instant auquel le ou les interrupteurs associés à l'obtention de la valeur $V_a$ doivent alors être ouverts, l'instant temporel $t_4$ formant un cinquième instant temporel de commutation correspondant à l'ouverture du ou des interrupteurs fermés précédemment en l'instant temporel $t_3$, $t_{3b}$.

Au cinquième instant temporel de commutation débute une cinquième phase V correspondant à une phase à charge sensiblement constante, ou encore en circuit sensiblement ouvert, cette cinquième phase V durant jusqu'à un instant temporel $t_5$ défini par le passage à une nouvelle valeur $V_c$ prédéfinie de la tension $V_p$ aux bornes de l'élément piézoélectrique 15. L'instant temporel $t_5$ formant la fin de la cinquième phase V correspond à la fermeture d'au moins un autre interrupteur respectif parmi les interrupteurs $K_1$, $K_2$, $K_3$, $K_4$, $K_5$, le ou les interrupteurs fermés en cet instant dépendant de la valeur $V_c$, la valeur $V_c$ étant par exemple égale à la tension nulle de la masse électrique 48, à la tension de sortie $V_{out}$, ou encore à l'opposé -$V_{out}$ de la tension de sortie $V_{out}$. L'instant temporel $t_5$ forme alors un sixième instant temporel de commutation.

A l'instant temporel $t_5$ débute alors la sixième phase VI correspondant à une phase à tension sensiblement constante à la valeur $V_c$, cette sixième phase VI durant jusqu'à l'instant temporel ta, ou encore jusqu'à un instant temporel $t_6$ modulo la période T du cycle de résonance défini par le passage à zéro du courant $I_L$ circulant dans l'élément piézoélectrique 15, et selon une monotonie opposée à celle du passage à zéro en l'instant temporel $t_3$. Par convention, l'instant temporel $t_6$ est égal à la somme de l'instant temporel $t_0$ et de la période T du cycle de résonance, et est également noté ($t_0$+T).

Dans l'exemple de la figure 2, l'instant temporel $t_6$ correspond à la fin d'un cycle de résonance de l'élément piézoélectrique 15, le cycle représenté ayant été défini par rapport aux instants temporels de passage à zéro du courant $I_L$ circulant dans l'élément piézoélectrique 15.

L'homme du métier observera alors que dans cet exemple du cycle de résonance à six phases obtenu avec le dispositif de pilotage de l'état de la technique, et présenté de façon générique pour différentes configurations C1 à C3 en regard de la figure 2, les trois phases à tension sensiblement constante correspondent aux valeurs $V_a$, $V_b$ et $V_c$ prédéfinies de la tension $V_p$ aux bornes de l'élément piézoélectrique 15, et les trois phases à charge sensiblement constante, ou encore en circuit ouvert, aux bornes de l'élément piézoélectrique 15 correspondent alors à des phases où la tension $V_p$ aux bornes de l'élément piézoélectrique 15 varie d'une valeur à l'autre parmi les trois valeurs $V_a$, $V_b$ et $V_c$ prédéfinies, précisément de la valeur $V_a$ à la valeur $V_c$, puis à la valeur $V_b$, et ainsi de suite dans l'exemple de la figure 2.

Par convention, lorsque le convertisseur 10 a pour but de fournir un courant positif sous une tension maximale $V_{max}$, les trois valeurs prédéfinies $V_a$, $V_b$ et $V_c$ sont classées par valeurs croissantes avec $V_a < V_b < V_c$, et le courant $I_L$ circulant dans l'élément piézoélectrique 15 est défini comme positif quand il contribue à fournir un courant positif sous la tension $V_{max}$. De manière complémentaire, lorsque le convertisseur 10 a pour but de tirer un courant positif sous la tension maximale $V_{max}$, les valeurs prédéfinies $V_a$, $V_b$ et $V_c$ sont classées de manière décroissante avec alors $V_a > V_b > V_c$, et le courant $I_L$ circulant dans l'élément piézoélectrique 15 est défini comme positif quand il contribue à tirer un courant positif sous la tension maximale $V_{max}$.

Dans les exemples des figures 3 à 5 obtenus avec le dispositif de pilotage 20 le nombre total de phases M est égal à huit, et les nombres Mv de phases à tension sensiblement constante et $M_C$ de phases à charge sensiblement constante sont chacun égal à quatre, les nombres E et N étant chacun égal à 1 dans ces exemples avec une seule tension d'entrée $V_{in}$ et une seule tension de sortie $V_{out}$.

Le dispositif de pilotage 20 selon l'invention, et en particulier le module de commande 60, est alors configuré pour commander chaque cycle respectif de résonance avec une phase supplémentaire à tension sensiblement constante, la tension étant à la valeur $V_{buffer}$ durant cette phase supplémentaire, le début de cette phase supplémentaire correspondant à l'instant temporel $t_{bs}$, et la fin de cette phase supplémentaire correspondant à un instant temporel $t_{be}$.

Dans les exemples des figures 3 à 5, cette phase supplémentaire à tension sensiblement constante à la valeur $V_{buffer}$ est ajoutée lors du premier demi-cycle où, par convention dans ces exemples, le courant $I_L$ circulant dans l'élément piézoélectrique 15 est négatif.

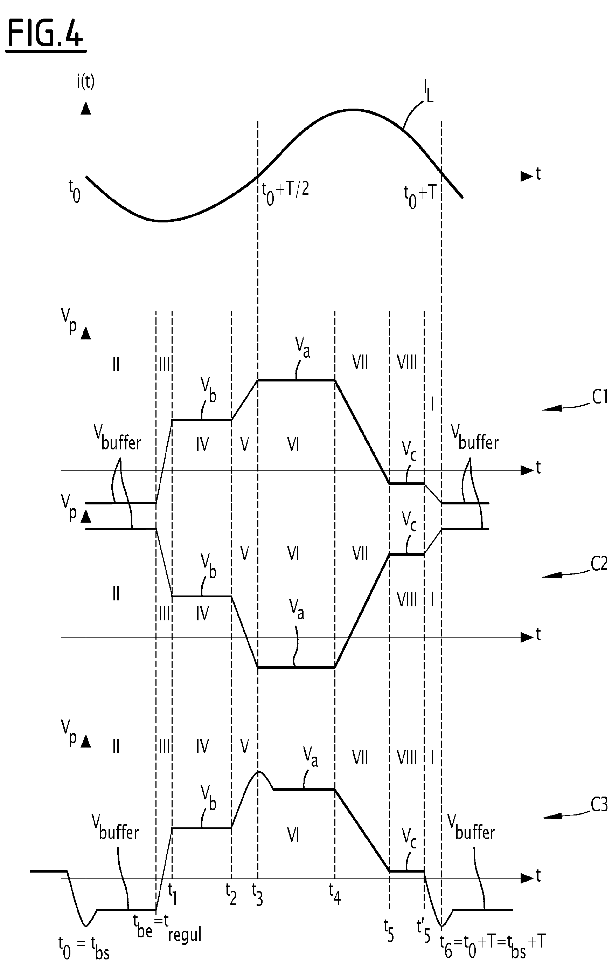

Dans les exemples des figures 3 et 4, la phase supplémentaire à tension sensiblement constante à la valeur $V_{buffer}$ est insérée entre les phases à tension sensiblement constante de valeur égale à $V_c$ et respectivement à $V_b$. Dans ces exemples, la phase supplémentaire à tension sensiblement constante à la valeur $V_{buffer}$ est notée II, la phase à tension sensiblement constante à la valeur $V_b$ étant notée IV, celle à la valeur $V_a$ étant notée VI, et enfin celle à la valeur $V_c$ étant notée VIII, les phases à charge sensiblement constante étant respectivement notées I, III, V et VII. Dans l'exemple de la figure 3, la valeur $V_{buffer}$ de la tension sensiblement constante lors de la phase supplémentaire est comprise entre les valeurs $V_b$ et $V_c$. Dans l'exemple de la figure 4, la valeur $V_{buffer}$ n'est pas comprise entre les valeurs $V_b$ et $V_c$, cette valeur $V_{buffer}$ étant par exemple inférieure à chacune des valeurs $V_a$, $V_b$ et $V_c$, et formant alors la plus faible valeur de tension sensiblement constante au cours du cycle de résonance, ceci pour les première et troisième configurations C1, C3 dans l'exemple de la figure 4 ; ou encore supérieure à chacune des valeurs $V_a$, $V_b$ et $V_c$, et formant alors la valeur la plus élevée de tension sensiblement constante au cours du cycle de résonance, comme pour la deuxième configuration C2 dans l'exemple de la figure 4.

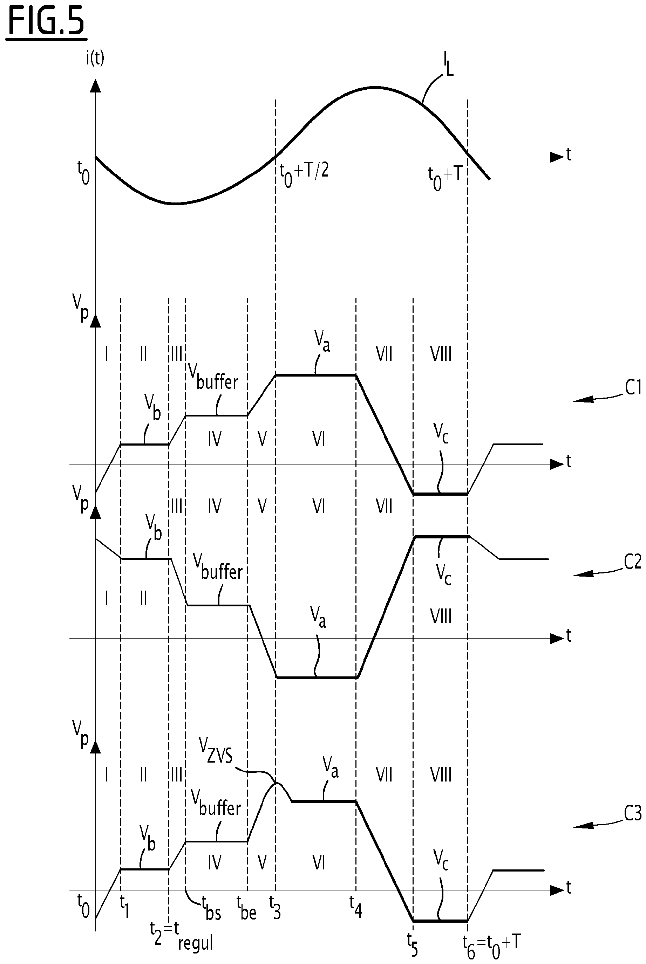

Dans l'exemple de la figure 5, la phase supplémentaire à tension sensiblement constante à la valeur $V_{buffer}$ est insérée entre la phase à tension sensiblement constante à la valeur $V_b$ et celle à la valeur $V_a$. Dans cet exemple, la valeur $V_{buffer}$ de la tension sensiblement constante lors de la phase supplémentaire est alors comprise entre les valeurs $V_b$ et $V_a$ Dans l'exemple de la figure 5, la phase supplémentaire à tension sensiblement constante à la valeur $V_{buffer}$ est alors notée IV, et celles à la tension $V_b$, $V_a$ et respectivement $V_c$ sont notées II, VI et respectivement VIII, les phases à charge sensiblement constante étant toujours notées I, III, V et VII, comme dans les exemples des figures 3 et 4.

Dans chacun des exemples des figures 3 à 5, l'instant temporel $t_{bs}$ formant le début de le phase supplémentaire à tension sensiblement constante à la valeur $V_{buffer}$ correspond à la fermeture d'au moins un interrupteur respectif parmi les interrupteurs $K_1$, $K_2$, $K_3$, $K_4$, $K_5$, le ou les interrupteurs fermés en cet instant dépendant de la valeur $V_{buffer}$. La valeur $V_{buffer}$ est par exemple égale à la tension nulle ou à la différence de tension $V_{out}-V_{in}$ égale à la tension de sortie $V_{out}$ moins la tension d'entrée $V_{in}$ dans l'exemple de la figure 3, à l'opposé $-V_{out}$ de la tension de sortie $V_{out}$, ou encore à la somme $V_{in}+V_{out}$ des tensions d'entrée $V_{in}$ et de sortie $V_{out}$ dans l'exemple de la figure 4 ; ou encore à la différence de tension $V_{in}-V_{out}$ égale à la tension d'entrée $V_{in}$ moins la tension de sortie $V_{out}$ dans les première et troisième configurations $C_1$, $C_3$ de la figure 5, et à la différence de tension $V_{out}-V_{in}$ égale à la tension de sortie $V_{out}$ moins la tension d'entrée $V_{in}$ dans la deuxième configuration $C_2$ de la figure 5.

Dans ces exemples des figures 3 à 5, l'instant temporel $t_{be}$ formant la fin de la phase supplémentaire à tension sensiblement constante à la valeur $V_{buffer}$ correspond alors à l'ouverture d'au moins un des interrupteurs précédemment fermés, la phase suivant la phase supplémentaire à tension sensiblement constante étant une phase à charge sensiblement constante, c'est-à-dire en circuit sensiblement ouvert, aux bornes de l'élément piézoélectrique 15, et nécessitant alors l'ouverture, d'une partie au moins, des interrupteurs $K_1$ à $K_5$.

Dans l'exemple de la figure 3, et de manière analogue à l'exemple de la figure 2, la valeur $V_a$ est typiquement égale à la tension d'entrée $V_{in}$ pour la première configuration $C_1$, à la tension -Vin opposée à la tension d'entrée $V_{in}$ pour la deuxième configuration $C_2$ et à la différence de tension $V_{in}$-$V_{out}$ égale à la tension d'entrée $V_{in}$ moins la tension de sortie $V_{out}$ pour la troisième configuration $C_3$.

Dans cet exemple de la figure 3, la valeur $V_b$ est alors par exemple égale à la tension de sortie $V_{out}$ pour les première et troisième configurations $C_1$, $C_3$, et à la tension d'entrée $V_{in}$ pour la deuxième configuration $C_2$. Dans cet exemple de la figure 3, la valeur $V_c$ est typiquement égale à l'opposé -$V_{out}$ de la tension de sortie $V_{out}$ pour les première et troisième configurations $C_1$, $C_3$, et à la tension de sortie $V_{out}$ pour la deuxième configuration $C_2$.

Dans l'exemple de la figure 4, la valeur $V_a$ est typiquement égale à la tension d'entrée $V_{in}$ pour la première configuration $C_1$, à l'opposé -$V_{out}$ de la tension de sortie $V_{out}$ pour la deuxième configuration $C_2$ et à la différence de tension $V_{in}$-$V_{eut}$ égale à la tension d'entrée $V_{in}$ moins la tension de sortie $V_{out}$ pour la troisième configuration $C_3$. La valeur $V_b$ est typiquement égale à la tension de sortie $V_{out}$ pour les première et troisième configurations $C_1$, $C_3$, à la tension d'entrée $V_{in}$ pour la deuxième configuration $C_2$. Dans cet exemple de la figure 4, la valeur $V_c$ est typiquement égale à la tension nulle pour les première et troisième configuration $C_1$, $C_3$, et à la différence de tension $V_{out}$-$V_{in}$ égale à la tension de sortie $V_{out}$ moins la tension d'entrée $V_{in}$ pour la deuxième configuration $C_2$.

Dans l'exemple de la figure 5, la valeur $V_a$ est par exemple égale à la tension d'entrée $V_{in}$ pour les première et troisième configurations $C_1$, $C_3$, et à l'opposé -$V_{in}$ de la tension d'entrée $V_{in}$ pour la deuxième configuration $C_2$. La valeur $V_b$ est par exemple égale à la tension de sortie $V_{out}$ pour les première et troisième configurations $C_1$, $C_3$, et à la tension d'entrée $V_{in}$ pour la deuxième configuration $C_2$. Dans cet exemple de la figure 5, la valeur $V_c$ est typiquement égale à la tension nulle pour la première configuration $C_1$, à la tension de sortie $V_{out}$ pour la deuxième configuration $C_2$ et à l'opposé -$V_{out}$ de la tension de sortie $V_{out}$ pour la troisième configuration $C_3$.

Dans les exemples des figures 3 à 5, les valeurs $V_a$, $V_b$, $V_c$, $V_{buffer}$ des tensions lors des phases à tension sensiblement constante sont toutes distinctes les unes des autres lors d'un cycle respectif de résonance.

Dans les exemples des figures 3 à 5, les valeurs $V_a$, $V_b$, $V_c$, $V_{buffer}$ des tensions lors des phases à tension sensiblement constante sont alors par exemple obtenues via la commutation des interrupteurs $K_1$ à $K_5$ du convertisseur 10 de la figure 1 pour les première et troisième configurations C1, C3, ou encore via la commutation des interrupteurs $K_1$ à $K_8$ du convertisseur de la figure 19 du document FR 3 086 472 A1 pour la deuxième configuration C2, selon les fermetures et ouvertures d'interrupteurs indiquées dans le tableau 1 ci-après.

Dans l'exemple des Figures 3 et 4 pour la troisième configuration C3, pour la fin de la phase à tension sensiblement constante à la valeur $V_b$, l'interrupteur $K_4$ peut être ouvert un peu plus tard, par exemple au passage par la valeur Vzvs en l'instant $t_3$ ; et pour le début de la phase à tension sensiblement constante à la valeur $V_a$, l'interrupteur $K_1$ peut être fermé un peu avant, par exemple au passage par la valeur Vzvs en l'instant $t_3$.

[Table 1]

| Figure | Configuration | Phase à tension sensiblement constante avec indication des interrupteurs fermés pendant ladite phase | Début | Fin |
|--------|---------------|---|---|---|
| Figure 3 | C1 | $V_{buffer}$ = 0 ($K_4$,$K_5$ fermés) | Fermeture $K_4$ | Ouverture $K_5$ |

(suite)

| Figure | Configuration | Phase à tension sensiblement constante avec indication des interrupteurs fermés pendant ladite phase | Début | Fin |
|---|---|---|---|---|
| | | $V_b = V_{out}$ ($K_2$,$K_4$ fermés) | Fermeture $K_2$ | Ouverture $K_2$ |
| | | $V_a = V_{in}$ ($K_1$, $K_4$ fermés) | Fermeture $K_1$ | Ouverture $K_1$, $K_4$ |
| | | $V_c = -V_{out}$ ($K_3$,$K_5$ fermés) | Fermeture $K_3$, $K_5$ | Ouverture $K_3$, $K_5$ |
| | C2 | $V_{buffer} = V_{out}-V_{in}$ ($K_2$, $K_4$, $K_5$, $K_7$ fermés) | Fermeture $K_7$ | Ouverture $K_2$, $K_5$, $K_7$ |
| | | $V_b = V_{in}$ ($K_1$, $K_6$, $K_4$, $K_8$ fermés) | Fermeture $K_1$, $K_6$, $K_8$ | Ouverture $K_1$, $K_6$ |
| | | $V_a = -V_{in}$ ($K_5$, $K_7$, $K_4$, $K_8$ fermés) | Fermeture $K_5$, K7 | Ouverture $K_7$, $K_8$ |
| | | $V_c = V_{out}$ ($K_5$, $K_6$, $K_2$, $K_4$ fermés) | Fermeture $K_6$, $K_2$ | Ouverture $K_6$ |
| | C3 | $V_{buffer} = 0$ ($K_4$, $K_5$ fermés) | Fermeture $K_4$ | Ouverture K5 |
| | | $V_b = V_{out}$ ($K_2$, $K_4$ fermés) | Fermeture $K_2$ | Ouverture $K_2$, ($K_4$) |
| | | $V_a = V_{in} - V_{out}$ ($K_1$, $K_3$ fermés) | Fermeture ($K_1$), $K_3$ | Ouverture $K_1$ |
| | | $V_c = -V_{out}$ ($K_3$, $K_5$ fermés) | Fermeture $K_5$ | Ouverture $K_3$ |

(suite)

| Figure | Configuration | Phase à tension sensiblement constante avec indication des interrupteurs fermés pendant ladite phase | Début | Fin |
|---|---|---|---|---|
| Figure 4 | C1 | $V_{buffer} = -V_{out}$ ($K_3$, $K_5$ fermés) | Fermeture $K_3$ | Ouverture $K_3$, $K_5$ |
| | | $V_b = V_{out}$ ($K_2$, $K_4$ fermés) | Fermeture $K_2$, $K_4$ | Ouverture $K_2$ |
| | | $V_a = V_{in}$ ($K_1$, $K_4$ fermés) | Fermeture $K_1$ | Ouverture $K_1$ |
| | | $V_c = 0$ ($K_4$, $K_5$ fermés) | Fermeture $K_5$ | Ouverture $K_4$ |
| | C2 | $V_{buffer} = V_{out}+V_{in}$ ($K_2$, $K_4$, $K_1$, $K_6$ fermés) | Fermeture $K_1$, $K_6$ | Ouverture $K_2$ |
| | | $V_b = V_{in}$ ($K_4$, $K_8$, $K_1$, $K_6$ fermés) | Fermeture $K_8$ | Ouverture $K_4$, $K_1$ |
| | | $V_a = -V_{out}$ ($K_3$, $K_8$, $K_5$, $K_6$ fermés) | Fermeture $K_3$, $K_5$ | Ouverture $K_3$, $K_8$, $K_7$ |
| | | $V_c = V_{out}-V_{in}$ ($K_2$, $K_4$, $K_5$, $K_7$ fermés) | Fermeture $K_2$, $K_4$, $K_7$ | Ouverture $K_5$, K7 |
| | C3 | $V_{buffer} = -V_{out}$ ($K_3$, $K_5$ fermés) | Fermeture $K_5$ | Ouverture $K_3$, $K_5$ |
| | | $V_b = V_{out}$ ($K_2$, $K_4$ fermés) | Fermeture $K_2$, $K_4$ | Ouverture $K_2$, $(K_4)$ |
| | | $V_a = V_{in}-V_{eut}$ ($K_1$, $K_3$ fermés) | Fermeture $(K_1)$, $K_3$ | Ouverture $K_1$ |
| | | $V_c = 0$ ($K_2$, $K_3$ fermés) | Fermeture $K_2$ | Ouverture $K_2$ |
| Figure 5 | C1 | $V_b = V_{out}$ ($K_2$, $K_4$ fermés) | Fermeture $K_2$ | Ouverture $K_2$, $K_4$ |
| | | $V_{buffer} = V_{in}-V_{out}$ ($K_1$, $K_3$ fermés) | Fermeture $K_1$, $K_3$ | Ouverture $K_3$ |
| | | $V_a = V_{in}$ ($K_1$, $K_4$ fermés) | Fermeture $K_4$ | Ouverture $K_2$ |
| | | $V_c = 0$ ($K_4$, $K_5$ fermés) | Fermeture $K_5$ | Ouverture $K_5$ |
| | C2 | $V_b = V_{in}$ ($K_4$, $K_8$, $K_1$, $K_6$ fermés) | Fermeture $K_8$, $K_1$ | Ouverture $K_8$, $K_1$, $K_6$ |

(suite)

| Figure | Configuration | Phase à tension sensiblement constante avec indication des interrupteurs fermés pendant ladite phase | Début | Fin |
|---|---|---|---|---|
| | | $V_{buffer} = V_{out}\text{-}V_{in}$ ($K_2$, $K_4$, $K_5$, $K_7$ fermés) | Fermeture $K_2$, $K_5$, $K_7$ | Ouverture $K_2$ |
| | | $V_a = \text{-}V_{in}$ ($K_4$, $K_8$, $K_5$, $K_7$ fermés) | Fermeture $K_8$ | Ouverture $K_8$, $K_7$ |
| | | $V_c = V_{out}$ ($K_2$, $K_4$, $K_5$, $K_6$ fermés | Fermeture $K_2$, $K_6$ | Ouverture $K_2$, $K_5$ |
| | C3 | $V_b = V_{out}$ ($K_2$, $K_4$ fermés) | Fermeture $K_2$, $K_4$ | Ouverture $K_2$, $K_4$ |
| | | $V_{buffer} = V_{in}\text{-}V_{out}$ ($K_1$, $K_3$ fermés) | Fermeture $K_1$, $K_3$ | Ouverture $K_3$ |
| | | $V_a = V_{in}$ ($K_1$, $K_4$ fermés) | Fermeture $K_4$ | Ouverture $K_1$, $K_4$ |
| | | $V_c = \text{-}V_{out}$ ($K_3$, $K_5$ fermés) | Fermeture $K_3$, $K_5$ | Ouverture $K_3$, $K_5$ |

En variante non représentée, la valeur $V_{buffer}$ de la tension lors de la phase supplémentaire à tension sensiblement constante au cours du premier demi-cycle est sensiblement égale à la valeur de la tension lors de l'une des phases à tension sensiblement constante au cours du second demi-cycle, telle que la valeur $V_a$ ou la valeur $V_c$. Selon cette variante, la valeur $V_{buffer}$ est alors typiquement sensiblement égale à la valeur $V_a$ ou à la valeur $V_c$.

Selon cette variante, les phases à tension sensiblement constante ayant sensiblement la même valeur de tension lors du premier demi-cycle et lors du second demi-cycle sont de préférence à la suite l'une de l'autre, et forment alors une même phase à tension sensiblement constante s'étendant sur deux demi-cycles successifs.

Selon cette variante, l'homme du métier observera en outre que lorsque la valeur $V_{buffer}$ est égale à la valeur $V_a$ ou à la valeur $V_c$, ceci formant une phase étendue à tension sensiblement constante, puisqu'elle s'étend sur deux demi-cycles successifs avec une inversion du signe du courant interne $I_L$ lors du passage d'un demi-cycle à l'autre, alors ladite phase à tension sensiblement constante s'étendant sur deux demi-cycles successifs est comptabilisée, compte tenu de ladite inversion du signe du courant interne $I_L$, comme deux phases au sens de la présente invention, et notamment de l'équation (1) précédente.

Selon cette variante, l'homme du métier observera en outre que le changement de signe du courant interne $I_L$ au cours de la phase étendue à tension sensiblement constante correspond au passage d'un demi-cycle à l'autre, c'est-à-dire à l'instant temporel $t_0$ ou encore à l'instant temporel $t_3$. En outre, ce changement de signe du courant interne $I_L$ lors de ladite phase étendue à tension sensiblement constante ne nécessite pas de commutation de l'un des interrupteurs $K_1$ à $K_5$ du convertisseur 10.

Selon cette variante, lorsque la valeur $V_{buffer}$ est égale à la valeur $V_c$, et que la phase supplémentaire à tension sensiblement constante suit immédiatement la phase à tension sensiblement constante à la valeur $V_c$, alors l'instant temporel $t_{bs}$ de début de cette phase supplémentaire est typiquement confondu avec l'instant temporel $t_6$. Cet instant temporel $t_6$ correspond à la fin de la phase à tension sensiblement constante à la valeur $V_c$ selon les exemples des figures 3 et 5. De manière analogue, l'homme du métier comprendra également que lorsque la valeur $V_{buffer}$ est égale à la valeur $V_a$, et que la phase supplémentaire à tension sensiblement constante précède immédiatement la phase à tension sensiblement constante à la valeur $V_a$, alors l'instant temporel $t_{be}$ de fin de cette phase supplémentaire est confondu avec l'instant temporel $t_3$ de début de la phase à tension sensiblement constante à la valeur $V_a$.

Différents exemples des valeurs $V_a$, $V_b$, $V_c$, $V_{buffer}$ de la tension de chacune des phases à tension sensiblement constante ont été décrits précédemment en regard des figures 3 à 5.

Plus généralement, la valeur $V_a$, $V_b$, $V_c$, $V_{buffer}$ de la tension de chacune des phases à tension sensiblement constante est choisie parmi le groupe consistant en : valeur nulle ; valeur $V_{in}$ ; $V_{ek}$ d'une tension d'entrée respective ; opposé $-V_{in}$ ; $-V_{ek}$ de la valeur d'une tension d'entrée respective ; valeur $V_{out}$ ; $V_{sl}$ d'une tension de sortie respective ; opposé $-V_{out}$ ; $-V_{sl}$ de la valeur d'une tension de sortie respective ; et combinaison linéaire $V_{in}\text{-}V_{out}$ ; $V_{out}\text{-}V_{in}$ ; $V_{in}\text{+}V_{out}$ ; $-Vin\text{-}Vout$ ; $V_{ek}\text{-}V_{sl}$ ; $V_{sl}\text{-}V_{ek}$ ; $V_{ek}\text{+}V_{sl}$ ; $-V_{ek}\text{-}V_{sl}$ des valeurs précitées ; la ou les tensions d'entrée étant notées $V_{ek}$ où k

est un indice entier associé à la tension d'entrée et compris entre 1 et E, et la ou les tensions de sortie distinctes étant notées $V_{sI}$, où I est un indice entier associé à la tension de sortie et compris entre 1 et N. Comme indiqué précédemment, dans le cas d'un convertisseur 10 à une seule tension d'entrée et une seule tension de sortie, la tension d'entrée et la tension de sortie sont respectivement notées $V_{in}$ et $V_{out}$ par souci de simplification des notations.

En régime établi, à tensions d'entrée/sortie constantes et à courant de sortie constant, il y a un équilibre entre la puissance apportée à l'élément piézoélectrique 15 et la puissance restituée par l'élément piézoélectrique 15, aux pertes précitées près. L'amplitude du courant $I_L$ circulant dans l'élément piézoélectrique 15 est alors constante, et la valeur $\hat{I}_L$ de cette amplitude du courant $I_L$ est directement liée au courant de sortie par l'équation suivante :

$$(5)$$

$$\widehat{I_L} = I_{L0} + \alpha . I_{out}$$

avec $I_{out}$ représentant le courant de sortie ;

$I_{L0}$ et $\alpha$ qui dépendent de la topologie utilisée et des valeurs des tensions d'entrée/sortie.

La valeur $\hat{I}_L$ de l'amplitude du courant $I_L$ en régime établi est également appelée amplitude utile.

Pour augmenter la puissance de sortie $P_{out}$ du convertisseur 10, et par exemple le courant de sortie $I_{out}$, il faut emmener le convertisseur 10 vers un nouvel état d'équilibre conduisant à une valeur plus élevée de l'amplitude utile $\hat{I}_L$ du courant interne, afin de pouvoir fournir le courant de sortie plus élevé demandé, selon l'équation (5) précédente.

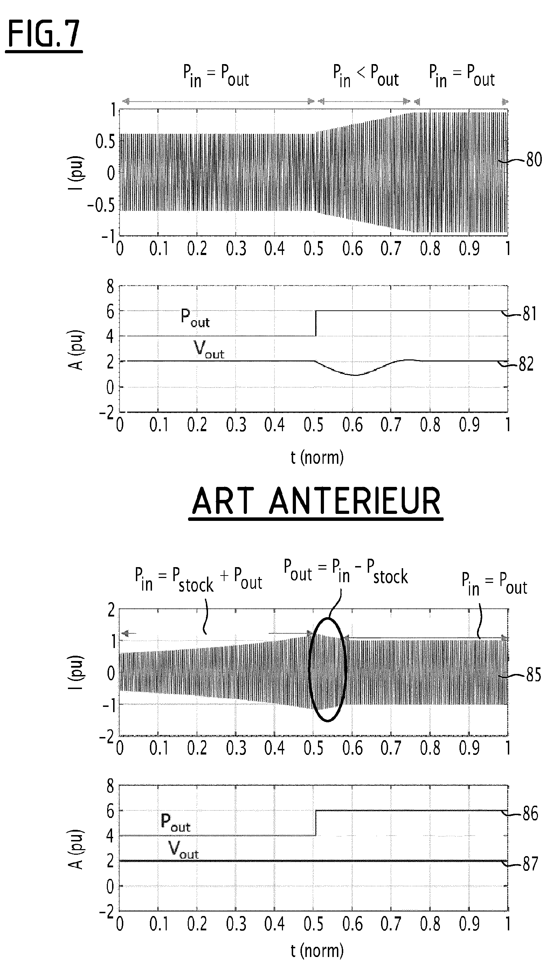

Avec le dispositif de pilotage de l'état de la technique, pour provoquer cette augmentation du courant interne $I_L$, il est nécessaire d'augmenter la puissance apportée à l'élément piézoélectrique 15 par rapport à ce que l'élément piézoélectrique 15 restitue. Ce déséquilibre de puissance conduit bien à une augmentation de l'amplitude du courant interne $I_L$ de l'élément piézoélectrique 15, comme montré à la figure 7 via la courbe 80 représentant le courant interne $I_L$ avec le dispositif de pilotage de l'état de la technique, les courbes 81 et 82 représentant respectivement la puissance de sortie $P_{out}$ et la tension de sortie $V_{out}$ du convertisseur 10 dans ce cas. Toutefois, durant ce transitoire, c'est-à-dire tant que l'amplitude utile $\hat{I}_L$ du courant interne n'a pas atteint sa nouvelle valeur, il n'est pas possible de fournir le nouveau courant demandé en sortie, ce qui conduit, par exemple, à une chute de la tension de sortie $V_{out}$ dans le cas d'une régulation de la tension de sortie, comme montré à la figure 7 via la courbe 82. De plus, ce régime transitoire peut durer plusieurs dizaines de cycles de résonance, c'est-à-dire quelques ms pour un fonctionnement à 100kHz.

Avec le dispositif de pilotage 20 selon l'invention, le deuxième degré de liberté apporté par la phase supplémentaire à tension sensiblement constante à la valeur $V_{buffer}$ permet de pré-positionner l'amplitude utile $\hat{I}_L$ du courant interne à une valeur plus élevée que ce qui était imposé par l'équation (5) précédente. Il est en effet possible, grâce à l'invention, d'intégrer à l'amplitude utile $\hat{I}_L$ du courant interne, un courant de réserve $I_{réserve}$, tel que décrit par l'équation suivante :

$$(6)$$

$$\widehat{I_L} = I_{L0} + \alpha . I_{out} + I_{réserve}$$

Ainsi, si le courant demandé en sortie augmente brutalement, le courant $I_L$ sera d'amplitude suffisante pour satisfaire immédiatement l'augmentation du courant de sortie, à partir du moment où le courant de réserve $I_{réserve}$ était supérieur à $\alpha * \Delta I_{out}$. Si le courant de réserve $I_{réserve}$ n'était pas suffisant, il aura néanmoins permis de réduire la durée du transitoire et donc de limiter la chute de la tension de sortie $V_{out}$.

Le dispositif de pilotage 20 selon l'invention permet alors, dans le cas idéal, de maintenir la tension de sortie $V_{out}$ à sa valeur de consigne durant tout le régime transitoire, comme montré à la figure 7 avec les courbe 85, 86 et 87 représentant respectivement le courant interne $I_L$, la puissance de sortie $P_{out}$ et la tension de sortie $V_{out}$ du convertisseur 10 en cas d'augmentation de la puissance de sortie $P_{out}$, avec le dispositif de pilotage 20 selon l'invention. Le dispositif de pilotage 20 selon l'invention permet a minima de limiter la chute de la tension de sortie $V_{out}$ si le courant demandé en sortie augmente brutalement. La réserve d'énergie tampon est ensuite reconstituée progressivement suite à cette variation de puissance, sans impacter la sortie.

Pour diminuer la puissance de sortie $P_{out}$ du convertisseur 10, l'amplitude $\hat{I}_L$ du courant interne doit diminuer jusqu'à atteindre une nouvelle valeur selon un nouveau régime permanent.

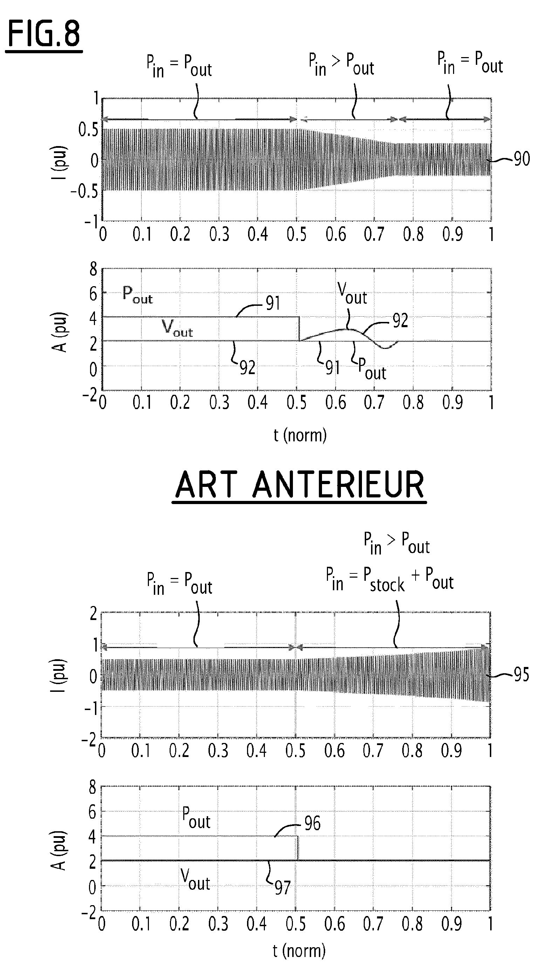

Avec le dispositif de pilotage de l'état de la technique, durant le régime transitoire correspondant à cette diminution de la puissance de sortie $P_{out}$, la puissance apportée à l'élément piézoélectrique 15 est réduite par rapport à ce que l'élément piézoélectrique 15 restitue, l'énergie mécanique stockée diminue. Durant ce transitoire, l'amplitude du courant $I_L$ diminue. Toutefois, durant ce transitoire, le courant $I_L$ est trop élevé par rapport au besoin et continue à produire une valeur de la puissance de sortie $P_{out}$ qui est supérieure à celle demandée, ce qui peut conduire à une surtension en sortie, comme montré à la figure 8 avec les courbe 90, 91 et 92 représentant respectivement le courant interne $I_L$, la puissance de sortie $P_{out}$ et la tension de sortie $V_{out}$ du convertisseur 10 en cas de diminution de la puissance de sortie $P_{out}$, avec le dispositif de pilotage de l'état de la technique, la courbe 92 montrant cette surtension après diminution de la puissance de sortie $P_{out}$. De plus, ce régime transitoire peut durer plusieurs dizaines de cycles de résonance, c'est-à-dire quelques ms pour un fonctionnement à 100kHz.

Avec le dispositif de pilotage 20 selon l'invention, le deuxième degré de liberté apporté par la phase supplémentaire à tension sensiblement constante à la valeur $V_{buffer}$ permet de réduire le courant de sortie $I_{out}$ au profit du courant de réserve $I_{réserve}$, selon l'équation (6) précédente. Le courant de sortie $I_{out}$ est donc modifiable quasi instantanément, c'est-à-dire après un ou quelques de cycles de résonance, pour satisfaire la consigne en tension de sortie $V_{out}$, ou en courant de sortie $I_{out}$ ou encore en puissance de sortie $P_{out}$.

Avec le dispositif de pilotage 20 selon l'invention, la tension de sortie $V_{out}$ est alors maintenue stable durant ce transitoire de diminution de la puissance de sortie $P_{out}$, comme montré à la figure 8 avec les courbe 95, 96 et 97 représentant respectivement le courant interne $I_L$, la puissance de sortie $P_{out}$ et la tension de sortie $V_{out}$ du convertisseur 10 en cas de diminution de la puissance de sortie $P_{out}$, avec le dispositif de pilotage 20 selon l'invention, la courbe 97 montrant une tension de sortie $V_{out}$ constante pendant la diminution de la puissance de sortie $P_{out}$.

Le courant de réserve $I_{réserve}$ étant, durant le transitoire, supérieur à la valeur souhaitée, par exemple celle décrite précédemment, alors le déséquilibre de puissance $P_{in}-P_{out}$ va perdurer jusqu'à ce que le courant de réserve $I_{réserve}$ revienne à sa valeur souhaitée.

Le courant de réserve $I_{réserve}$ correspond physiquement à une réserve d'énergie mécanique, l'amplitude du courant $I_L$ étant une image de l'amplitude de la déformation mécanique de l'élément piézoélectrique 15, et donc de l'énergie cinétique et potentielle du matériau piézoélectrique.

Le courant de réserve $I_{réserve}$ formant une réserve d'énergie tampon est déterminée, de différentes manières possibles :

- sur demande : la charge 22, tel qu'un circuit alimenté, envoie un signal au convertisseur 10 pour anticiper une demande de courant ou de puissance. Dans un exemple où le circuit consomme peu en mode veille, avant de procéder au réveil du circuit, une demande d'augmentation du courant $I_L$ est effectuée de sorte à anticiper l'appel de puissance du circuit lors de son réveil effectif, et ainsi éviter une chute transitoire de sa tension d'alimentation, correspondant à la tension de sortie $V_{out}$ du convertisseur 10 ;
- constante : la valeur du courant de réserve $I_{réserve}$ est constante et prédéfinie ;
- proportionnée : la valeur du courant de réserve $I_{réserve}$ est proportionnelle au courant de sortie $I_{out}$ ou encore l'amplitude utile $\hat{I}_L$, par exemple égale à 0,2 fois l'amplitude $\hat{I}_L$ du courant interne ;
- nominale : le courant interne $I_L$ est maintenu à une certaine valeur nominale quel que soit le courant de sortie $I_{out}$. Cela permet de maximiser la disponibilité au détriment des pertes : plus le courant $I_L$ est élevé, plus il y a de pertes ;
- pour suivre un certain profil de consommation de la source 24, comme par exemple dans le cas d'une absorption d'un courant sinusoïdal sur le réseau électrique, ou encore l'exemple de l'exploitation d'une source d'énergie variable dont on cherche à maximiser à chaque instant la puissance extraite. La source d'énergie variable est par exemple un récupérateur d'énergie ambiante, telle qu'une énergie rayonnante (solaire, infrarouge, radiofréquence), une énergie thermique, une énergie mécanique (vibratoire, déformation, déplacement relatif) ;
- pour ramener, à une valeur de consigne, l'instant temporel $t_{be}$ de fin de la phase supplémentaire, ou l'instant de fin de la phase à tension constante qui précède la phase supplémentaire ou bien la durée de la phase supplémentaire, ou encore tout paramètre associé à l'une des deux grandeurs précitées.

Pour la régulation mise en oeuvre par le module de régulation 62, la grandeur $G_{out}$ représentative de la sortie du convertisseur 10 est par exemple la tension de sortie $V_{out}$, le courant de sortie $I_{out}$, ou encore la puissance de sortie $P_{out}$. La première boucle de régulation 70 permet alors de réguler la tension de sortie $V_{out}$, le courant de sortie $I_{out}$, ou encore la puissance de sortie $P_{out}$, alors que la deuxième boucle de régulation 72, plus lente que la première boucle de régulation 70, typiquement au moins dix fois plus lente, permet de réguler la réserve d'énergie.

La première boucle de régulation 70 est alors configurée pour maintenir la tension de sortie $V_{out}$, le courant de sortie $I_{out}$, ou encore la puissance de sortie $P_{out}$ à une valeur de consigne en agissant sur le premier paramètre $\delta_{buffer}$. Le premier paramètre $\delta_{buffer}$ est typiquement associé à un instant temporel de régulation $t_{regul}$ régulant la durée de la phase supplémentaire à tension sensiblement constante égale à la valeur $V_{buffer}$. Dans les exemples des figures 3 et 4, l'instant de régulation $t_{regul}$ est l'instant temporel $t_{be}$ de fin de ladite phase supplémentaire à tension sensiblement constante ; et dans l'exemple de la figure 5, l'instant de régulation $t_{regul}$ est l'instant temporel $t_2$ correspondant à la fin de la phase à tension sensiblement constante égale à la valeur $V_b$.

Lorsque l'instant de régulation $t_{regul}$ est l'instant $t_{be}$, comme dans les exemples des figures 3 et 4, le premier paramètre $\delta_{buffer}$ vérifie typiquement l'une des équations suivantes :

(7)
$$\delta_{buffer} = \frac{(t_{be} - t_{bs})}{T}$$

(8)
$$\delta_{buffer} = \frac{(t_{be} - t_0)}{T}$$

(9)
$$\delta_{buffer} = \frac{t_{be}}{T}$$

(10)
$$\delta_{buffer} = t_{be}$$

où T représente la période du cycle de résonance de l'élément piézoélectrique 15,

$t_{be}$ et $t_{bs}$ représentent respectivement les instants temporels de fin et de début de la phase supplémentaire à tension sensiblement constante égale à la valeur $V_{buffer}$, et

$t_0$ représente le premier instant temporel de commutation correspondant au passage par zéro et par valeurs décroissantes du courant $I_L$ interne à l'élément piézoélectrique 15.

Lorsque l'instant temporel de régulation $t_{regul}$ est l'instant temporel $t_2$, comme dans l'exemple de la figure 5, le premier paramètre $\delta_{buffer}$ vérifie typiquement l'une des équations suivantes :

(11)
$$\delta_{buffer} = \frac{(t_2 - t_1)}{T}$$

(12)
$$\delta_{buffer} = \frac{(t_2 - t_0)}{T}$$

(13)
$$\delta_{buffer} = \frac{t_2}{T}$$

(14)
$$\delta_{buffer} = t_2$$

où T représente la période du cycle de résonance de l'élément piézoélectrique 15,

$t_2$ et $t_1$ représentent respectivement les instants temporels de fin et de début de la phase à tension sensiblement constante égale à la valeur $V_b$, et

$t_0$ représente le premier instant temporel de commutation correspondant au passage par zéro et par valeurs décroissantes du courant $I_L$ interne à l'élément piézoélectrique 15.

Pour la première boucle de régulation 70, le module de régulation 62 est alors typiquement configuré pour comparer la grandeur $G_{out}$ représentative de la sortie du convertisseur 10 avec sa valeur de consigne $G_{out\_cons}$ via un premier comparateur 74, ou premier soustracteur, puis pour agir sur le premier paramètre $\delta_{buffer}$ via un premier correcteur 75 recevant à son entrée le résultat de la comparaison ou soustraction issue du premier comparateur 74, ou premier soustracteur, et délivrant à sa sortie le premier paramètre $\delta_{buffer}$. Une constante de temps de la première boucle de régulation 70 est typiquement de l'ordre de quelques périodes du cycle de résonance de l'élément piézoélectrique 15, et par exemple sensiblement égale à dix fois la période T dudit cycle de résonance.

En complément facultatif encore, le module de régulation 62 est configuré pour borner le premier paramètre $\delta_{buffer}$ entre des valeurs minimale et maximale prédéfinies, de telle manière que la durée de la phase supplémentaire à tension sensiblement constante égale à la valeur $V_{buffer}$, correspondant à la différence $t_{be}-t_{bs}$ des instants temporels de fin et de début de ladite phase supplémentaire, soit toujours comprise entre une valeur nulle et une valeur maximale prédéfinie. Cette valeur maximale prédéfinie est typiquement inférieure à T/2, i.e. la moitié de la période T du cycle de résonance de l'élément piézoélectrique 15.

La deuxième boucle de régulation 72 permet d'effectuer la gestion de l'énergie tampon, en agissant sur la durée de la phase d'apport de l'énergie par l'intermédiaire du deuxième paramètre $t_4$ correspondant à la fin de la phase à tension sensiblement constante égale à la valeur $V_a$. La deuxième boucle de régulation 72 permet notamment de contrôler un déséquilibre entre la puissance apportée à l'élément piézoélectrique 15 et la puissance restituée, c'est-à-dire de contrôler le niveau de la réserve d'énergie. La réserve d'énergie est déterminée via un paramètre de réserve $\beta$ vérifiant par exemple l'une des équations suivantes :

$$(15) \qquad \beta = \frac{I_{réserve}}{\widehat{I}_L}$$

$$(16) \qquad \beta = A$$

$$(17) \qquad \beta = \delta_{buffer}$$

$$(18) \qquad \beta = \widehat{I}_L$$

$$(19) \qquad \beta = I_{in}$$

où $I_{réserve}$ représente le courant de réserve, et $\widehat{I}_L$ représente l'amplitude utile du courant interne, telle que définie selon l'équation (6) précédente,

A représente un pourcentage prédéfini, tel que 1000%, représentant typiquement un ratio entre la quantité de réserve d'énergie et la quantité d'énergie échangée au cours d'un cycle, et

$\delta_{buffer}$ représente le premier paramètre de régulation.

$I_{in}$ représente le courant en entrée du convertisseur 10, par exemple pour suivre un certain profil de consommation sur l'entrée

Pour la deuxième boucle de régulation 72, le module de régulation 62 est alors configuré pour comparer le paramètre de réserve $\beta$ avec sa valeur de consigne $\beta_{\_cons}$ via un deuxième comparateur 76, ou deuxième soustracteur, puis pour agir sur le deuxième paramètre $t_4$ via un deuxième correcteur 77 recevant à son entrée le résultat de la comparaison ou soustraction issue du deuxième comparateur 76, ou deuxième soustracteur, et délivrant à sa sortie le deuxième paramètre $t_4$. La constante de temps de la deuxième boucle de régulation 72 est supérieure à la constante de temps de la première boucle de régulation 70. A titre d'exemple, la constante de temps de la deuxième boucle de régulation de temps 72 est sensiblement égale à dix fois la constante de temps de la première boucle de régulation 70.

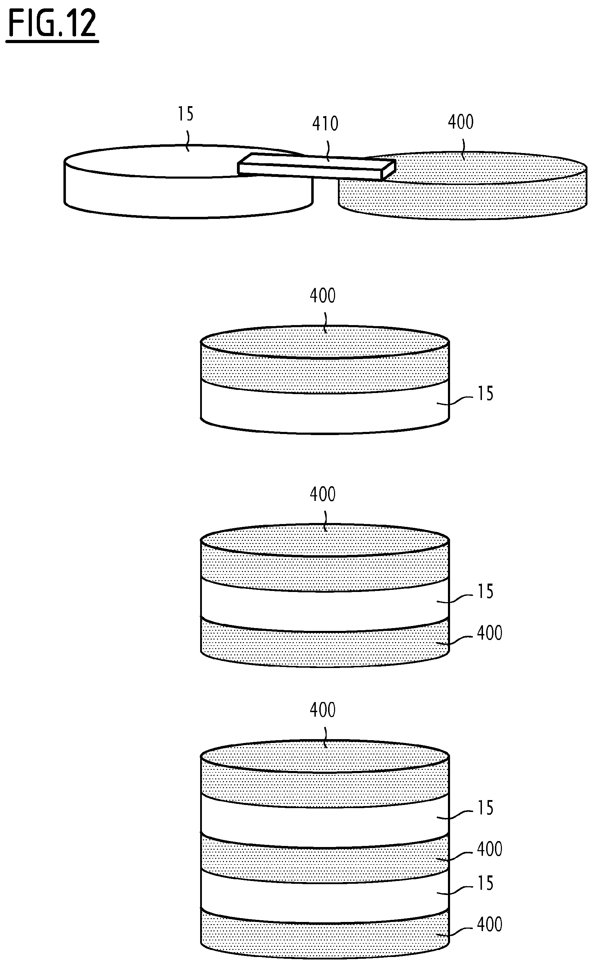

En complément facultatif, au moins une masse additionnelle 400 est couplée mécaniquement à l'élément piézoélectrique 15, et permet d'échanger de l'énergie mécanique avec l'élément piézoélectrique 15, comme représenté sur la figure 12.

Selon ce complément facultatif, quand l'énergie électrique apportée à l'élément piézoélectrique 15 est supérieure à celle qu'il restitue sous forme électrique ou en dissipation thermique, alors à l'élément piézoélectrique 15 entraine la masse additionnelle, et stocke via celle-ci de l'énergie mécanique sous forme d'oscillations mécaniques. Inversement, quand l'élément piézoélectrique 15 reçoit moins d'énergie qu'il n'en restitue sous forme électrique ou thermique, alors la masse additionnelle tend à maintenir l'oscillation de l'élément piézoélectrique 15.

Selon ce complément facultatif, la masse additionnelle se comporte alors comme un second réservoir d'énergie mécanique avec lequel le l'élément piézoélectrique 15 peut échanger via un couplage mécanique, tel que collage, serrage, bras mécanique, etc. Un autre avantage est alors de remplacer un condensateur (chimique, céramique) par la masse additionnelle.

La figure 12 illustre alors différents exemples de couplage mécanique de l'au moins une masse additionnelle 400 avec l'élément piézoélectrique 15.

Selon un premier exemple, représenté en partie supérieure de la figure 12, l'élément piézoélectrique 15 est couplé mécaniquement avec la masse additionnelle 400 via un bras mécanique 410. L'élément piézoélectrique 15 et la masse additionnelle 400 sont par exemple disposés l'un à côté de l'autre.

Selon un deuxième exemple, représenté en dessous du premier exemple à la figure 12, l'élément piézoélectrique 15 et la masses additionnelles 400 sont superposés, c'est-à-dire sont disposés l'un au-dessus de l'autre, ou encore sont empilés. Selon ce deuxième exemple, l'élément piézoélectrique 15 et la masse additionnelle 400 sont couplés mécaniquement typiquement par collage ou serrage.

Selon un troisième exemple, représenté en dessous du deuxième exemple à la figure 12, l'élément piézoélectrique 15 est couplé à plusieurs masses additionnelles 400.

Selon le troisième exemple, l'élément piézoélectrique 15 est pris en sandwich entre deux masses additionnelles 400. L'élément piézoélectrique 15 et les masses additionnelles 400 sont alors superposés, ou encore empilés, avec une masse additionnelle 400 en dessous de l'élément piézoélectrique 15 et l'autre masse additionnelle 400 au-dessus de l'élément piézoélectrique 15. Selon ce troisième exemple, l'élément piézoélectrique 15 et les masses additionnelles 400 sont couplés mécaniquement typiquement par collage ou serrage.

Selon un quatrième exemple, représenté en dessous du troisième exemple et en bas de la figure 12, plusieurs éléments piézoélectriques 15 sont couplés mécaniquement avec plusieurs masses additionnelles 400. Selon cet exemple, l'élément piézoélectrique 15 et les masses additionnelles 400 sont couplés mécaniquement par collage ou serrage typiquement.

Dans ce quatrième exemple, deux éléments piézoélectriques 15 sont couplés mécaniquement avec trois masses additionnelles 400, sous forme d'un empilement avec une alternance d'élément piézoélectrique 15 et de masse additionnelle 400. Dans cet exemple, une première masse additionnelle 400 est disposée sous un premier élément piézoélectrique 15, lui-même disposé sous une deuxième masse additionnelle 400, elle-même disposée sous un deuxième élément piézoélectrique 15, enfin lui-même disposé sous une troisième masse additionnelle 400.

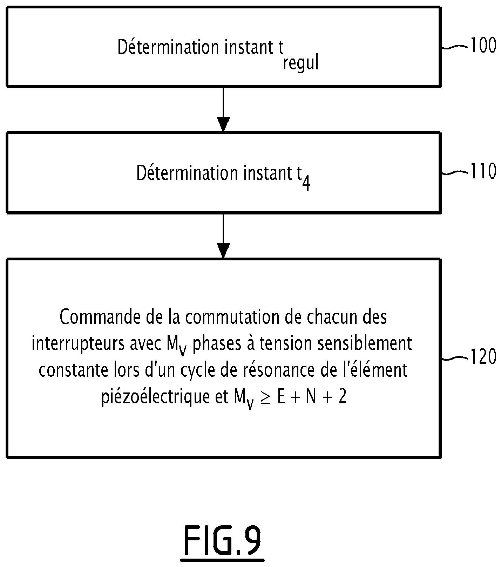

Le fonctionnement du convertisseur d'énergie électrique 10, et en particulier du dispositif électronique de pilotage 20, selon l'invention va être à présent décrit en regard de la figure 9 représentant un organigramme d'un procédé, selon l'invention, de pilotage du convertisseur d'énergie électrique 10, le procédé étant mis en oeuvre par le dispositif électronique de pilotage 20.

Lors d'une étape 100, le dispositif de pilotage 20 détermine, via son module de régulation 62, l'instant temporel de régulation $t_{regul}$ en fonction de la grandeur $G_{out}$ représentative de la sortie du convertisseur 10. Lors de cette première étape de détermination 100, le module de régulation 62 détermine typiquement cet instant de régulation $t_{regul}$ via la première boucle de régulation 70.

Lors de l'étape suivante 110, le dispositif de pilotage 20 détermine, via son module de régulation 62, l'instant temporel $t_4$ correspondant au deuxième paramètre de régulation en fonction du niveau souhaité de réserve d'énergie ou bien en fonction du premier paramètre $\delta_{buffer}$. Lors de cette deuxième étape de détermination 110, le module de régulation 62 détermine typiquement cet instant temporel $t_4$ via la deuxième boucle de régulation 72.

A l'issue des première et deuxième étapes de détermination 100, 110 et de la détermination associée des instants temporels $t_{regul}$ et $t_4$ correspondant aux deux degrés de liberté de la régulation du convertisseur 10, le dispositif de pilotage 20 passe à l'étape suivante 120 lors de laquelle il commande, via son module de commande 60, la commutation de chacun des interrupteurs $K_1$ à $K_5$ du convertisseur 10 pour alterner des phases à tension sensiblement constante aux bornes 30, 34 de l'élément piézoélectrique 15 et des phases à charge sensiblement constante aux bornes 30, 34 dudit élément piézoélectrique 15.

Lors de cette étape de commande 120, selon l'invention, le nombre $M_V$ de phases à tension sensiblement constante, telles que les phases II, IV, VI, VIII, lors d'un cycle respectif de résonance de l'élément piézoélectrique 15 est supérieur ou égal à la somme du nombre E de tension(s) d'entrée distincte(s), du nombre N de tension(s) de sortie distincte(s) et de deux, ce nombre Mv vérifiant l'équation (1) précédente. En outre, chacun des premier et second demi-cycles comporte au moins deux phases à tension sensiblement constante. Dans l'exemple des figures 3 à 5, le premier demi-cycle comporte ainsi les phases II, IV à tension sensiblement constante, et le second demi-cycle comporte les phases VI, VIII à tension sensiblement constante.

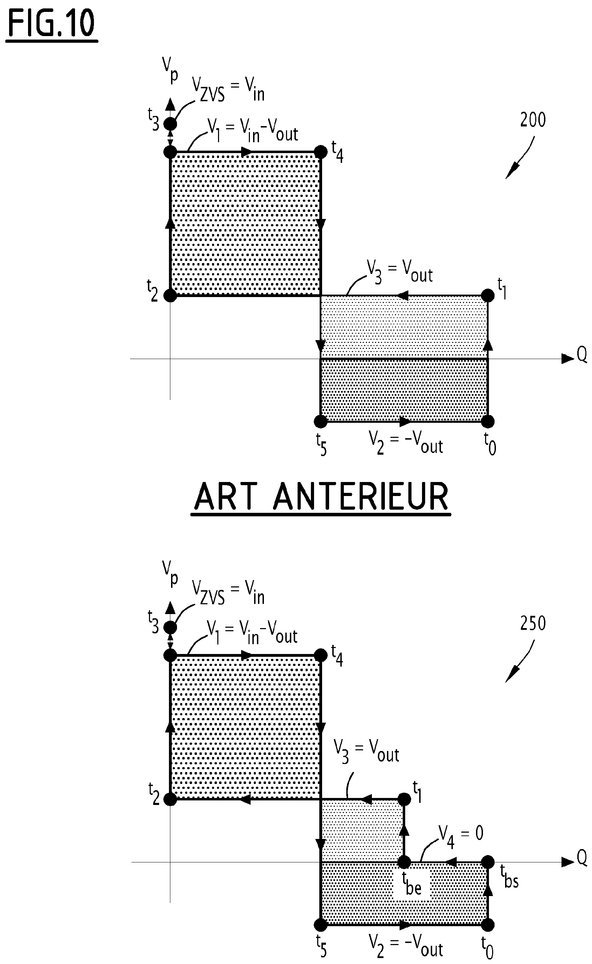

La figure 10 représentant, d'une part, un premier cycle de conversion 200 en représentation $V_p$ versus Q obtenu avec le dispositif de pilotage de l'état de la technique, et d'autre part, un deuxième cycle de conversion 250 en représentation $V_p$ versus Q obtenu avec le dispositif de pilotage 20 selon l'invention, en particulier pour les exemples des figures 3 et 4, permet alors de montrer la différence en termes de degré de liberté pour la régulation du convertisseur d'énergie électrique 10 entre le dispositif de pilotage de l'état de la technique et le dispositif de pilotage 20 selon l'invention. En effet, le premier cycle de conversion 200 en représentation $V_p$ versus Q montre un unique degré de liberté pour la régulation du convertisseur 10, cet unique degré de liberté correspondant à l'instant temporel $t_4$ ; alors que le deuxième cycle de conversion 250 en représentation $V_p$ versus Q montre les deux degrés de liberté pour la régulation du convertisseur 10 avec le dispositif de pilotage 20 selon l'invention, un premier degré de liberté correspondant à l'instant temporel $t_4$, comme pour le dispositif de pilotage de l'état de la technique, et un deuxième degré de liberté correspondant à l'instant temporel $t_{be}$. Ce deuxième degré de liberté forme alors un degré de liberté supplémentaire pour la régulation du convertisseur d'énergie électrique 10 par rapport au procédé de pilotage de l'état de la technique.

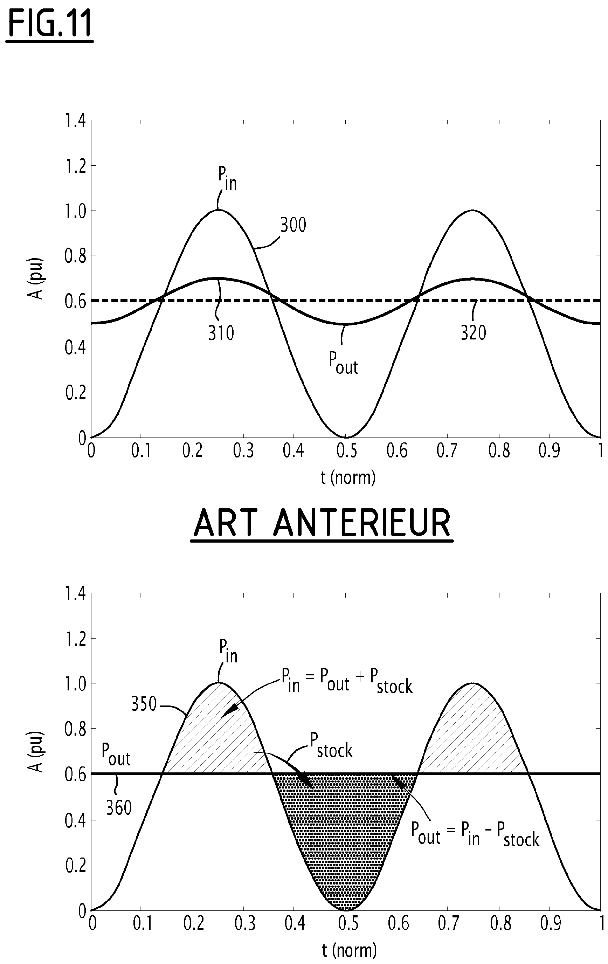

Sur la figure 11 représentant des courbes de puissance d'entrée $P_{in}$ et de sortie $P_{out}$ dans le cas où le système de conversion 5 est de type alternatif-continu à absorption sinusoïdale, une première courbe de puissance d'entrée 300 et une première courbe de puissance de sortie 310 correspondent respectivement aux puissance d'entrée $P_{in}$ et de sortie $P_{out}$ obtenues avec le dispositif de pilotage de l'état de la technique, la droite 320 en trait pointillé représentant la valeur moyenne de la puissance de sortie $P_{out}$ ; et une deuxième courbe de puissance d'entrée 350 et une deuxième courbe de puissance de sortie 360 correspondent respectivement aux puissances d'entrée $P_{in}$ et de sortie $P_{out}$ obtenues avec le dispositif de pilotage 20 selon l'invention.

L'homme du métier observera alors que la puissance de sortie $P_{out}$ obtenue avec le dispositif de pilotage de l'état de la technique comporte des oscillations, visibles sur la première courbe de puissance de sortie 310, et qu'il est alors généralement nécessaire de rajouter un condensateur de filtrage, potentiellement volumineux, ainsi qu'un circuit élévateur (de l'anglais *Boost*) de type PFC (de l'anglais *Power Factor Corrector*), pour assurer un prélèvement de courant sinusoïdal en phase avec la tension réseau.

Pour une telle application où le système de conversion 5 est de type alternatif-continu à absorption sinusoïdale, le dispositif de pilotage 20 selon l'invention permet alors de stocker une partie de l'énergie prélevée à la source dans l'élément piézoélectrique 15 quand la puissance d'entrée $P_{in}$ est supérieure à la puissance de sortie $P_{out}$, la puissance stockée étant notée $P_{stock}$ à la figure 11, et ensuite de restituer cette puissance stockée $P_{stock}$ à la sortie quand la puissance d'entrée $P_{in}$ est inférieure à la puissance de sortie $P_{out}$. Ceci permet alors de fournir une puissance de sortie $P_{out}$ sensiblement constante comme montré par la deuxième courbe de puissance de sortie 360 en forme de droite, alors que la puissance prélevée sur le réseau est sinusoïdale. Le dispositif de pilotage 20 selon l'invention permet alors de réduire, voire de supprimer, le condensateur de filtrage précité.

On conçoit ainsi que le dispositif électronique de pilotage 20 et le procédé de pilotage associé permettent d'offrir un pilotage amélioré du convertisseur d'énergie électrique 10, notamment une meilleure régulation dudit convertisseur 10.

**Revendications**

1. Dispositif électronique (20) de pilotage d'un convertisseur d'énergie électrique (10) apte à convertir une ou plusieurs tensions d'entrée en une ou plusieurs tensions de sortie, le convertisseur (10) étant configuré pour délivrer N tension(s) de sortie distincte(s), à partir de E tension(s) d'entrée distincte(s), E et N étant chacun un nombre entier supérieur ou égal à 1, le convertisseur (10) comportant un élément piézoélectrique (15) et plusieurs interrupteurs ($K_1$, $K_2$, $K_3$, $K_4$, $K_5$),

   le dispositif électronique de pilotage (20) comprenant un module (60) de commande configuré pour commander, lors d'un cycle respectif de résonance de l'élément piézoélectrique (15), une commutation de chacun des interrupteurs ($K_1$, $K_2$, $K_3$, $K_4$, $K_5$) pour alterner des phases (II, IV, VI, VIII) à tension sensiblement constante aux bornes (30, 34) de l'élément piézoélectrique (15) et des phases (I, III, V, VII) à charge sensiblement constante aux bornes (30, 34) dudit élément piézoélectrique (15), chaque cycle de résonance comportant des premier et second demi-cycles, un courant ($I_L$) circulant selon un premier sens dans l'élément piézoélectrique (15) lors du premier demi-cycle et selon un second sens, opposé au premier sens, lors du second demi-cycle, où, par tension sensiblement constante, on entend une variation de tension inférieure à 20%, de préférence inférieure à 10%, de la tension d'entrée ou de sortie du convertisseur (10) et, par charge sensiblement constante, on entend un échange d'une charge avec l'extérieur qui est inférieur à 10% de la charge qui aurait été échangée avec l'extérieur si la tension avait été maintenue constante,

le nombre ($M_V$) de phases (II, IV, VI, VIII) à tension sensiblement constante lors d'un cycle respectif de résonance étant supérieur ou égal à la somme de E, N et deux, et chacun des premier et second demi-cycles comportant au moins deux phases (II, IV ; VI, VIII) à tension sensiblement constante, et

**caractérisé en ce que** la valeur ($V_{buffer}$) de la tension de l'une des phases (II, IV, VI, VIII) à tension sensiblement constante lors du premier demi-cycle est sensiblement égale à la valeur ($V_a$, $V_c$) de la tension de l'une des phases (II, IV, VI, VIII) à tension sensiblement constante lors du second demi-cycle, où l'expression « sensiblement égal(e) à » définit une relation d'égalité à plus ou moins 10%, de préférence à plus ou moins 5%.

2. Dispositif (20) selon la revendication 1, dans lequel le nombre ($M_V$) de phases (II, IV, VI, VIII) à tension sensiblement constante lors d'un cycle respectif de résonance est égal à la somme de E, N et deux.

3. Dispositif (20) selon la revendication 1 ou 2, dans lequel le nombre total (M) de phases (II, IV, VI, VIII) à tension sensiblement constante et de phases (I, III, V, VII) à charge sensiblement constante lors d'un cycle respectif de résonance est supérieur ou égal à quatre plus deux fois la somme de E et N.

4. Dispositif (20) selon l'une quelconque des revendications 1 à 3, dans lequel les phases à tension sensiblement constante ayant sensiblement la même valeur de tension lors du premier cycle et lors du second cycle sont à la suite l'une de l'autre ; et forment de préférence une même phase à tension sensiblement constante s'étendant sur deux demi-cycles successifs.

5. Dispositif (20) selon l'une quelconque des revendications précédentes, dans lequel la valeur ($V_a$, $V_b$, $V_c$, $V_{buffer}$) de la tension de chacune des phases (II, IV, VI, VIII) à tension sensiblement constante est choisie parmi le groupe consistant en : valeur nulle ; valeur ($V_{in}$ ; $V_{ek}$) d'une tension d'entrée respective ; opposé ($-V_{in}$ ; $-V_{ek}$) de la valeur d'une tension d'entrée respective ; valeur ($V_{out}$ ; $V_{sl}$) d'une tension de sortie respective ; opposé ($-V_{out}$; $-V_{sl}$) de la valeur d'une tension de sortie respective ; et combinaison linéaire ($V_{in}-V_{out}$ ; $V_{out}-V_{in}$ ; $V_{in}+V_{out}$ ; $-V_{in}-V_{out}$ ; $V_{ek}-V_{sl}$ ; $V_{sl}-V_{ek}$ ; $V_{ek}+V_{sl}$ ; $-V_{ek}-V_{sl}$) des valeurs précitées.

6. Dispositif (20) selon l'une quelconque des revendications précédentes, dans lequel le dispositif comprend en outre un module (62) de régulation configuré pour réguler un premier paramètre ($\delta_{buffer}$) associé au premier demi-cycle et un deuxième paramètre ($t_4$) associé au deuxième demi-cycle, chacun des premier ($\delta_{buffer}$) et deuxième ($t_4$) paramètres étant une variable représentative d'un instant temporel de fin d'une phase respective à tension sensiblement constante.

7. Dispositif (20) selon la revendication 6, dans lequel le premier paramètre ($\delta_{buffer}$) est régulé en fonction d'une grandeur ($V_{out}$, $I_{out}$, $P_{out}$) représentative de la sortie du convertisseur (10), et le deuxième paramètre ($t_4$) est régulé en fonction d'un niveau souhaité de réserve d'énergie ou bien en fonction du premier paramètre ($\delta_{buffer}$).

8. Dispositif (20) selon la revendication 6 ou 7, dans lequel le premier paramètre ($\delta_{buffer}$) est régulé via une première boucle de régulation, et le deuxième paramètre ($t_4$) est régulé via une deuxième boucle de régulation, distincte de la première boucle de régulation ;

la première boucle de régulation étant de préférence plus rapide que la deuxième boucle de régulation.

9. Système électronique de conversion d'énergie électrique (5) comprenant :

- un convertisseur d'énergie électrique (10) comportant un élément piézoélectrique (15) et plusieurs interrupteurs ($K_1$, $K_2$, $K_3$, $K_4$, $K_5$) aptes à être commandés pour alterner des phases (II, IV, VI, VIII) à tension sensiblement constante aux bornes (30, 34) de l'élément piézoélectrique (15) et des phases (I, III, V, VII) à charge sensiblement constante aux bornes (30, 34) dudit élément piézoélectrique (15) ; et
- un dispositif électronique (20) de pilotage du convertisseur d'énergie électrique (10) ;

**caractérisé en ce que** le dispositif de pilotage (20) est selon l'une quelconque des revendications précédentes.

10. Système (5) selon la revendication précédente, dans lequel le système électronique de conversion d'énergie électrique (5) est un système de conversion en une énergie électrique continue, tel qu'un système de conversion continu-continu ou un système de conversion alternatif-continu.

11. Procédé de pilotage d'un convertisseur d'énergie électrique (10) apte à convertir une tension d'entrée en une tension de sortie, le convertisseur (10) étant configuré pour délivrer N tension(s) de sortie distincte(s), à partir de E tension(s) d'entrée distincte(s), E et N étant chacun un nombre entier supérieur ou égal à 1, le convertisseur (10) comportant un élément piézoélectrique (15) et plusieurs interrupteurs ($K_1$, $K_2$, $K_3$, $K_4$, $K_5$),

le procédé étant mis en oeuvre par un dispositif électronique de pilotage (20) et comprenant une étape de commande, lors d'un cycle respectif de résonance de l'élément piézoélectrique (15), d'une commutation de chacun des interrupteurs ($K_1$, $K_2$, $K_3$, $K_4$, $K_5$) pour alterner des phases (II, IV, VI, VIII) à tension sensiblement constante aux bornes (30, 34) de l'élément piézoélectrique (15) et des phases (I, III, V, VII) à charge sensiblement constante aux bornes (30, 34) dudit élément piézoélectrique (15), chaque cycle de résonance comportant des premier et second demi-cycles, un courant ($I_L$) circulant selon un premier sens dans l'élément piézoélectrique (15) lors du premier demi-cycle et selon un second sens, opposé au premier sens, lors du second demi-cycle, où, par tension sensiblement constante, on entend une variation de tension inférieure à 20%, de préférence inférieure à 10%, de la tension d'entrée ou de sortie du convertisseur (10) et, par charge sensiblement constante, on entend un échange d'une charge avec l'extérieur qui est inférieur à 10% de la charge qui aurait été échangée avec l'extérieur si la tension avait été maintenue constante,

le nombre ($M_V$) de phases (II, IV, VI, VIII) à tension sensiblement constante lors d'un cycle respectif de résonance étant supérieur ou égal à la somme de E, N et deux, et chacun des premier et second demi-cycles comportant au moins deux phases (II, IV ; VI, VIII) à tension sensiblement constante, et

**caractérisé en ce que** la valeur ($V_{buffer}$) de la tension de l'une des phases (II, IV, VI, VIII) à tension sensiblement constante lors du premier demi-cycle est sensiblement égale à la valeur ($V_a$, $V_c$) de la tension de l'une des phases (II, IV, VI, VIII) à tension sensiblement constante lors du second demi-cycle, où l'expression « sensiblement égal(e) à » définit une relation d'égalité à plus ou moins 10%, de préférence à plus ou moins 5%.

**Patentansprüche**

1. Elektronische Vorrichtung (20) zur Steuerung eines Wandlers elektrischer Energie (10), der imstande ist, eine oder mehrere Eingangsspannungen in eine oder mehrere Ausgangsspannungen umzuwandeln, wobei der Wandler (10) so konfiguriert ist, dass er N unterschiedliche Ausgangsspannungen aus E unterschiedlichen Eingangsspannungen bereitstellt, wobei E und N jeweils eine ganze Zahl größer oder gleich 1 sind, wobei der Wandler (10) ein piezoelektrisches Element (15) und mehrere Schalter ($K_1$, $K_2$, $K_3$, $K_4$, $K_5$) aufweist, wobei die elektronische Steuerungsvorrichtung (20) ein Steuermodul (60) umfasst, das so konfiguriert ist, dass es während eines jeweiligen Resonanzzyklus des piezoelektrischen Elements (15) ein Umschalten jedes der Schalter ($K_1$, $K_2$, $K_3$, $K_4$, $K_5$) steuert, um zwischen Phasen (II, IV, VI, VIII) mit im Wesentlichen konstanter Spannung an den Anschlüssen (30, 34) des piezoelektrischen Elements (15) und Phasen (I, III, V, VII) mit im Wesentlichen konstanter Last an den Anschlüssen (30, 34) des piezoelektrischen Elements (15) abzuwechseln, wobei jeder Resonanzzyklus einen ersten und zweiten Halbzyklus umfasst, wobei ein Strom ($I_L$) während des ersten Halbzyklus in einer ersten Richtung und während des zweiten Halbzyklus in einer zweiten Richtung, die der ersten Richtung entgegengesetzt ist, durch das piezoelektrische Element (15) fließt, wobei unter im Wesentlichen konstanter Spannung eine Spannungsschwankung unter 20 %, vorzugsweise unter 10 %, der Eingangs- oder Ausgangsspannung des Wandlers (10) verstanden wird, und unter im Wesentlichen konstanter Last ein Austausch einer Last mit außerhalb verstanden wird, der kleiner als 10 % der Last ist, die mit außerhalb ausgetauscht werden würde, wenn die Spannung konstant gehalten worden wäre, wobei die Anzahl ($M_v$) der Phasen (II, IV, VI, VIII) mit im Wesentlichen konstanter Spannung während eines jeweiligen Resonanzzyklus größer oder gleich der Summe von E, N und zwei ist, und jeder von dem ersten und zweiten Halbzyklus mindestens zwei Phasen (II, IV; VI, VIII) mit im Wesentlichen konstanter Spannung aufweist, und **dadurch gekennzeichnet ist, dass** der Wert ($V_{buffer}$) der Spannung einer der Phasen (II, IV, VI, VIII) mit im Wesentlichen konstanter Spannung während des ersten Halbzyklus im Wesentlichen gleich dem Wert ($V_a$, $V_c$) der Spannung einer der Phasen (II, IV, VI, VIII) mit im Wesentlichen konstanter Spannung während des zweiten Halbzyklus ist, wobei der Ausdruck "im Wesentlichen gleich wie" ein Gleichheitsverhältnis von mehr oder weniger als 10 %, vorzugsweise von mehr oder weniger als 5 %, definiert.

2. Vorrichtung (20) nach Anspruch 1, wobei die Anzahl ($M_v$) der Phasen (II, IV, VI, VIII) mit im Wesentlichen konstanter Spannung während eines jeweiligen Resonanzzyklus gleich der Summe von E, N und zwei ist.

3. Vorrichtung (20) nach Anspruch 1 oder 2, wobei die Gesamtzahl (M) der Phasen (II, IV, VI, VIII) mit im Wesentlichen konstanter Spannung und der Phasen (I, III, V, VII) mit im Wesentlichen konstanter Last während eines jeweiligen Resonanzzyklus größer oder gleich vier plus zweimal die Summe von E und N ist.

4. Vorrichtung (20) nach einem der Ansprüche 1 bis 3, wobei die Phasen mit im Wesentlichen konstanter Spannung, die im ersten Zyklus und im zweiten Zyklus im Wesentlichen denselben Spannungswert aufweisen, aufeinander folgen; und bilden vorzugsweise eine einzige Phase mit im Wesentlichen konstanter Spannung, die sich über zwei aufeinanderfolgende Halbzyklen erstreckt.

5. Vorrichtung (20) nach einem der vorhergehenden Ansprüche, wobei der Wert ($V_a$, $V_b$, $V_c$, $V_{buffer}$) der Spannung jeder der Phasen (II, IV, VI, VIII) mit im Wesentlichen konstanter Spannung aus der Gruppe ausgewählt ist, die besteht aus: Wert Null; Wert ($V_{in}$; $V_{ek}$) einer jeweiligen Eingangsspannung; dem gegenüberliegenden Wert ($-V_{in}$; $-V_{ek}$) einer jeweiligen Eingangsspannung; Wert ($V_{out}$; $V_{sl}$) einer jeweiligen Ausgangsspannung; dem gegenüberliegenden Wert ($-V_{out}$; $-V_{sl}$) einer jeweiligen Ausgangsspannung; und Linearkombination ($V_{in}-V_{out}$; $V_{out}-V_{in}$; $V_{in}+V_{out}$; $-V_{in}-V_{out}$; $V_{ek}-V_{sl}$; $V_{sl}-V_{ek}$; $V_{ek}+V_{sl}$; $-V_{ek}-V_{sl}$) der vorgenannten Werte.

6. Vorrichtung (20) nach einem der vorhergehenden Ansprüche, wobei die Vorrichtung ferner ein Regelmodul (62) umfasst, das so konfiguriert ist, dass es einen ersten Parameter ($\delta_{buffer}$), der dem ersten Halbzyklus zugeordnet ist, und einen zweiten Parameter ($t_4$), der dem zweiten Halbzyklus zugeordnet ist, regelt, wobei jeder von dem ersten ($\delta_{buffer}$) und zweiten ($t_4$) Parameter eine Variable ist, die für einen Zeitpunkt des Endes einer jeweiligen Phase mit im Wesentlichen konstanter Spannung repräsentativ ist.

7. Vorrichtung (20) nach Anspruch 6, wobei der erste Parameter ($\delta_{buffer}$) in Abhängigkeit von einer Größe ($V_{out}$, $I_{out}$, $P_{out}$) geregelt wird, die für den Ausgang des Wandlers (10) repräsentativ ist, und der zweite Parameter ($t_4$) in Abhängigkeit von einem gewünschten Niveau der Energiereserve oder alternativ in Abhängigkeit vom ersten Parameter ($\delta_{buffer}$) geregelt wird.

8. Vorrichtung (20) nach Anspruch 6 oder 7, wobei der erste Parameter ($\delta_{buffer}$) über einen ersten Regelkreis geregelt wird und der zweite Parameter ($t_4$) über einen zweiten Regelkreis geregelt wird, der vom ersten Regelkreis unterschiedlich ist;
wobei der erste Regelkreis vorzugsweise schneller als der zweite Regelkreis ist.

9. Elektronisches System zur Umwandlung von elektrischer Energie (5), umfassend:

- einen Wandler elektrischer Energie (10), der ein piezoelektrisches Element (15) und mehrere Schalter ($K_1$, $K_2$, $K_3$, $K_4$, $K_5$) aufweist, die imstande sind, so gesteuert zu werden, dass sie zwischen Phasen (II, IV, VI, VIII) mit im Wesentlichen konstanter Spannung an den Anschlüssen (30, 34) des piezoelektrischen Elements (15) und Phasen (I, III, V, VII) mit im Wesentlichen konstanter Last an den Anschlüssen (30, 34) des piezoelektrischen Elements (15) abzuwechseln; und
- eine elektronische Steuerungsvorrichtung (20) des Wandlers elektrischer Energie (10);

**dadurch gekennzeichnet, dass** die Steuerungsvorrichtung (20) nach einem der vorhergehenden Ansprüche ist.

10. System (5) nach vorhergehendem Anspruch, wobei das elektronische System zur Umwandlung elektrischer Energie (5) ein System zur Umwandlung in eine kontinuierliche elektrische Energie ist, wie ein Gleichstrom-Gleichstrom-Wandlungssystem oder ein Wechselstrom-Gleichstrom-Wandlungssystem.

11. Verfahren zur Steuerung eines Wandlers elektrischer Energie (10), der imstande ist, eine Eingangsspannung in eine Ausgangsspannung umzuwandeln, wobei der Wandler (10) so konfiguriert ist, dass er N unterschiedliche Ausgangsspannungen aus E unterschiedlichen Eingangsspannungen bereitstellt, wobei E und N jeweils eine ganze Zahl größer oder gleich 1 sind, wobei der Wandler (10) ein piezoelektrisches Element (15) und mehrere Schalter ($K_1$, $K_2$, $K_3$, $K_4$, $K_5$) aufweist,

wobei das Verfahren von einer elektronischen Steuerungsvorrichtung (20) durchgeführt wird und einen Schritt des Steuerns, während eines jeweiligen Resonanzzyklus des piezoelektrischen Elements (15), eines Umschaltens jedes der Schalter ($K_1$, $K_2$, $K_3$, $K_4$, $K_5$) umfasst, um zwischen Phasen (II, IV, VI, VIII) mit im Wesentlichen konstanter Spannung an den Anschlüssen (30, 34) des piezoelektrischen Elements (15) und Phasen (I, III, V, VII) mit im Wesentlichen konstanter Last an den Anschlüssen (30, 34) des piezoelektrischen Elements (15) abzuwechseln, wobei jeder Resonanzzyklus einen ersten und zweiten Halbzyklus umfasst, wobei ein Strom ($I_L$) während des ersten Halbzyklus in einer ersten Richtung und während des zweiten Halbzyklus in einer zweiten Richtung, die der ersten Richtung entgegengesetzt ist, durch das piezoelektrische Element (15) fließt, wobei unter im Wesentlichen konstanter Spannung eine Spannungsschwankung unter 20 %, vorzugsweise unter 10 %, der Eingangs- oder Ausgangsspannung des Wandlers (10) verstanden wird, und unter im Wesentlichen konstanter Last ein Austausch einer Last mit außerhalb verstanden wird, der kleiner als 10 % der Last ist, die mit außerhalb ausgetauscht werden würde, wenn die Spannung konstant gehalten worden wäre, wobei die Anzahl ($M_V$) der Phasen (II, IV, VI, VIII) mit im Wesentlichen konstanter Spannung während eines jeweiligen Resonanzzyklus größer oder gleich der Summe von E, N und zwei ist, und jeder von dem ersten und zweiten Halbzyklus mindestens zwei Phasen (II, IV; VI, VIII) mit im Wesentlichen konstanter Spannung aufweist, und **dadurch gekennzeichnet ist, dass** der Wert ($V_{buffer}$) der Spannung einer der Phasen (II, IV, VI, VIII) mit im Wesentlichen konstanter Spannung während des ersten Halbzyklus im Wesentlichen gleich dem Wert ($V_a$, $V_c$) der Spannung einer der Phasen (II, IV, VI, VIII) mit im Wesentlichen konstanter Spannung während des zweiten Halbzyklus ist, wobei der Ausdruck "im Wesentlichen gleich wie" ein Gleichheitsverhältnis von mehr oder weniger als 10 %, vorzugsweise von mehr oder weniger als 5 %, definiert.

**Claims**

1. Electronic controlling device (20) for controlling an electrical energy converter (10) capable of converting one or more input voltages into one or more output voltages, the converter (10) being configured to deliver N distinct output voltage(s), from E distinct input voltage(s), E and N each being an integer greater than or equal to 1, the converter (10) comprising a piezoelectric element (15) and several switches ($K_1$, $K_2$, $K_3$, $K_4$, $K_5$),

   the electronic control device (20) comprising a control module (60) configured to control, during a respective resonance cycle of the piezoelectric element (15), a switching of each of the switches ($K_1$, $K_2$, $K_3$, $K_4$, $K_5$) to alternate phases (II, IV, VI, VIII) at substantially constant voltage at the terminals (30, 34) of the piezoelectric element (15) and phases (I, III, V, VII) at substantially constant charge at the terminals (30, 34) of said piezoelectric element (15), each resonance cycle comprising first and second half-cycles, a current ($I_L$) flowing in a first direction in the piezoelectric element (15) during the first half-cycle and in a second direction, opposite to the first direction, during the second half-cycle, where by substantially constant voltage is meant a voltage variation of less than 20%, preferably less than 10%, of the input or output voltage of converter (10), and by substantially constant charge is meant an exchange of a charge with the outside which is less than 10% of the charge which would have been exchanged with the outside if the voltage had been kept constant,
   the number ($M_V$) of phases (II, IV, VI, VIII) at substantially constant voltage during a respective resonance cycle being greater than or equal to the sum of E, N and two, and each of the first and second half-cycles comprising at least two phases (II, IV; VI, VIII) at substantially constant voltage, and
   **characterized in that** the value ($V_{buffer}$) of the voltage of one of the phases (II, IV, VI, VIII) at substantially constant voltage during the first half-cycle is substantially equal to the value ($V_a$, $V_c$) of the voltage of one of the phases (II, IV, VI, VIII) at substantially constant voltage during the second half-cycle, where the expression "substantially equal to" defines a relation of equality at plus or minus 10%, preferably at plus or minus 5%.

2. Device (20) according to claim 1, wherein the number ($M_V$) of phases (II, IV, VI, VIII) at substantially constant voltage during a respective resonance cycle is equal to the sum of E, N and two.

3. Device (20) according to claim 1 or 2, wherein the total number (M) of substantially constant voltage phases (II, IV, VI, VIII) and of substantially constant charge phases (I, III, V, VII) during a respective resonance cycle is greater than or equal to four plus twice the sum of E and N.

4. Device (20) according to any one of claims 1 to 3, wherein the substantially constant voltage phases having substantially the same voltage value during the first cycle and during the second cycle are one after the other; and preferably form the same phase at substantially constant voltage extending over two successive half-cycles.

5. Device (20) according to any one of the preceding claims, wherein the value ($V_a$, $V_b$, $V_c$, $V_{buffer}$) of the voltage of each of the phases (II, IV, VI, VIII) at substantially constant voltage is chosen from the group consisting of: null value; value ($-V_{in}$; $-V_{ek}$) of a respective input voltage; opposite ($-V_{in}$; $-V_{ek}$) of the value of a respective input voltage; value ($V_{out}$; $V_{sl}$) of a respective output voltage; opposite ($-V_{out}$; $-V_{sl}$) of the value of a respective output voltage; and linear combination ($V_{in}-V_{out}$; $V_{out}-V_{in}$; $V_{in}+V_{out}$; $-V_{in}-V_{out}$; $V_{ek}-V_{sl}$; $U_{sl}-V_{ek}$; $V_{ek}+V_{sl}$; $-V_{ek}-V_{sl}$) of the aforementioned values.

6. Device (20) according to any one of the preceding claims, wherein the device further comprises a regulation module (62) configured to regulate a first parameter ($\delta_{buffer}$) associated with the first half-cycle and a second parameter ($t_4$)

associated in the second half-cycle, each of the first ($\delta_{buffer}$) and second ($t_4$) parameters being a variable representing a time instant of the end of a respective phase at substantially constant voltage.

7. Device (20) according to claim 6, wherein the first parameter ($\delta_{buffer}$) is regulated as a function of a quantity ($V_{out}$, $I_{out}$, $P_{out}$) representative of the output of the converter (10), and the second parameter ($t_4$) is regulated according to a desired level of energy reserve or else according to the first parameter ($\delta_{buffer}$).

8. Device (20) according to claim 6 or 7, wherein the first parameter ($\delta_{buffer}$) is regulated via a first regulation loop, and the second parameter ($t_4$) is regulated via a second regulation loop, distinct from the first regulation loop; the first regulation loop preferably being faster than the second regulation loop.

9. Electronic conversion system (5) for converting electrical energy, comprising:

   - an electrical energy converter (10) comprising a piezoelectric element (15) and several switches ($K_1$, $K_2$, $K_3$, $K_4$, $K_5$) capable of being controlled to alternate phases (II, IV, VI, VIII) at substantially constant voltage at the terminals (30, 34) of the piezoelectric element (15) and phases (I, III, V, VII) at substantially constant charge at the terminals (30, 34) of said piezoelectric element (15); and
   - an electronic controlling device (20) for controlling the electrical energy converter (10);

   **characterized in that** the controlling device (20) is according to any one of the preceding claims.

10. System (5) according to the preceding claim, wherein the electronic conversion system (5) for converting electrical energy is a system for converting into DC electrical energy, such as a DC-DC conversion system or an AC-DC conversion system.

11. Method for controlling an electrical energy converter (10) capable of converting an input voltage into an output voltage, the converter (10) being configured to deliver N distinct output voltage(s), from E distinct input voltage(s), E and N each being an integer greater than or equal to 1, the converter (10) comprising a piezoelectric element (15) and several switches ($K_1$, $K_2$, $K_3$, $K_4$, $K_5$),

   the method being implemented by an electronic control device (20) and comprising a step of controlling, during a respective resonance cycle of the piezoelectric element (15), a switching of each of the switches ($K_1$, $K_2$, $K_3$, $K_4$, $K_5$) to alternate phases (II, IV, VI, VIII) at substantially constant voltage at the terminals (30, 34) of the piezoelectric element (15) and phases (I, III, V, VII) at substantially constant charge at the terminals (30, 34) of said piezoelectric element (15), each resonance cycle comprising first and second half-cycles, a current ($I_L$) flowing in a first direction in the piezoelectric element (15) during the first half-cycle and in a second direction, opposite to the first direction, during the second half-cycle, where by substantially constant voltage is meant a voltage variation of less than 20%, preferably less than 10%, of the input or output voltage of converter (10), and by substantially constant charge is meant an exchange of a charge with the outside which is less than 10% of the charge which would have been exchanged with the outside if the voltage had been kept constant, the number ($M_V$) of phases (II, IV, VI, VIII) at substantially constant voltage during a respective resonance cycle being greater than or equal to the sum of E, N and two, and each of the first and second half-cycles comprising at least two phases (II, IV; VI, VIII) at substantially constant voltage, and **characterized in that** the value ($V_{buffer}$) of the voltage of one of the phases (II, IV, VI, VIII) at substantially constant voltage during the first half-cycle is substantially equal to the value ($V_a$, $V_c$) of the voltage of one of the phases (II, IV, VI, VIII) at substantially constant voltage during the second half-cycle, where the expression "substantially equal to" defines a relation of equality at plus or minus 10%, preferably at plus or minus 5%.

<u>FIG.1</u>

# FIG.2

# FIG.3

# FIG.4

# FIG.5

**FIG.6**

## FIG.7

$P_{in} = P_{out}$    $P_{in} < P_{out}$    $P_{in} = P_{out}$

## ART ANTERIEUR

$P_{in} = P_{stock} + P_{out}$    $P_{out} = P_{in} - P_{stock}$    $P_{in} = P_{out}$

# FIG.8

$P_{in} = P_{out}$  $P_{in} > P_{out}$  $P_{in} = P_{out}$

$P_{out}$  91

$V_{out}$  $V_{out}$  92

92  91  $P_{out}$

t (norm)

# ART ANTERIEUR

$P_{in} > P_{out}$

$P_{in} = P_{out}$  $P_{in} = P_{stock} + P_{out}$

$P_{out}$  96

$V_{out}$  97

t (norm)

Détermination instant $t_{regul}$ ~100

Détermination instant $t_4$ ~110

Commande de la commutation de chacun des interrupteurs avec $M_V$ phases à tension sensiblement constante lors d'un cycle de résonance de l'élément piézoélectrique et $M_V \geq E + N + 2$ ~120

## FIG.9

# FIG.10

$V_p$

$V_{ZVS} = V_{in}$

$t_3$

$V_1 = V_{in} - V_{out}$

$t_4$

200

$t_2$

$V_3 = V_{out}$

$t_1$

Q

$t_5$

$V_2 = -V_{out}$

$t_0$

## ART ANTERIEUR

$V_p$

$V_{ZVS} = V_{in}$

$t_3$

$V_1 = V_{in} - V_{out}$

$t_4$

250

$t_2$

$V_3 = V_{out}$

$t_1$

$V_4 = 0$

$t_{be}$

$t_{bs}$

Q

$t_5$

$V_2 = -V_{out}$

$t_0$

# FIG.11

## ART ANTERIEUR

# FIG.12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3064850 B1
- FR 3086471 A1
- FR 3086472 A1
- WO 2020252250 A2

**Littérature non-brevet citée dans la description**

- **MUSTAPHA TOUHAMI et al.** Implementation of control strategy for step-down dc-dc converter based on piezoelectric resonator. *EPE '20 ECCE Europe,* 1-9